# EUROPEAN PATENT APPLICATION

(11) **EP 4 766 080 A1**
(43) Date of publication of application: **24.06.2026**
(21) Application number: 25185034.3
(22) Date of filing: 24.06.2025
(51) Int. Cl.: H10D 30/66, H10D 64/23, H10D 84/00

(54) **SEMICONDUCTOR DEVICE**

(30) Priority: 19.12.2024 KR 20240191027
(71) Applicant: Samsung Electronics Co., Ltd., Suwon-si, Gyeonggi-do 16677 (KR)
(72) Inventor: KIM, Taehun, Suwon-si (KR); PARK, Young Hwan, Suwon-si (KR); PARK, Jeonghwan, Suwon-si (KR); OH, Sewoong, Suwon-si (KR); WOO, Sangsu, Suwon-si (KR)
(74) Representative: Marks & Clerk LLP

(57) **Abstract**

Provided is semiconductor device including a substrate including a cell region, a first conductivity type semiconductor layer positioned on an upper surface of the substrate, a second conductivity type doping well region positioned within the first conductivity type semiconductor layer, a gate electrode positioned on the first conductivity type semiconductor layer, a gate insulation layer positioned between the first conductivity type semiconductor layer and the gate electrode, a source electrode positioned on the second conductivity type doping well region, and a drain electrode positioned below the bottom surface of the substrate. The source electrode includes, a first source electrode positioned on the gate electrode, a second source electrode positioned on the first source electrode, and a resistance layer positioned between the first source electrode and the second source electrode, and including a conductive material having a greater electrical resistance than that of the first source electrode.

## Description

### BACKGROUND

Power semiconductor devices are used in various fields such as transportation fields including electric vehicles, railroads, and electric trams, renewable energy systems including solar power generation and wind power generation, and mobile devices. Power semiconductor devices handle high voltage or high current, and perform functions such as power conversion and control in large power systems or high-output electronic devices. Power semiconductor devices have the ability and durability to handle high power, so they can handle large amounts of current and withstand high voltage. For example, power semiconductor devices can handle voltages from hundreds of volts to thousands of volts and currents from tens of amperes to thousands of amperes. Power semiconductor devices can improve the efficiency of electrical energy by minimizing power loss. Additionally, power semiconductor devices can be stably driven even in environments such as high temperatures.

### SUMMARY

Some aspects of the present disclosure provide semiconductor devices that can prevent short-circuits by reducing saturation drain current (Idₛₐₜ) without changing the drain/source on-resistance (Rdsₒₙ), without changing the structure in the active source contact region, such as changing the channel length, and/or without adding additional resistance external to the circuit (e.g., package or module). In addition, the current spreading can be improved by reducing the current concentration of the active source contact and improving voltage overshooting or non-uniformity of the source current by cell region position.

A semiconductor device according to one aspect includes a substrate including a cell region and a peripheral region positioned outside the cell region, a first conductivity type semiconductor layer positioned on an upper surface of the substrate, a second conductivity type doping well region positioned within the first conductivity type semiconductor layer, a gate electrode positioned on the first conductivity type semiconductor layer, a gate insulation layer positioned between the first conductivity type semiconductor layer and the gate electrode, a source electrode positioned on the second conductivity type doping well region, and a drain electrode positioned below the bottom surface of the substrate, wherein the source electrode includes, a first source electrode positioned on the gate electrode, a second source electrode positioned on the first source electrode, and a resistance layer positioned between the first source electrode and the second source electrode, and including a conductive material having a greater electrical resistance than that of the first source electrode.

A semiconductor device according to another aspect includes a substrate comprising a cell region and a peripheral region positioned outside the cell region, a first conductivity type semiconductor layer positioned on the upper surface of the substrate, a second conductivity type doping well region positioned within the first conductivity type semiconductor layer, a gate electrode positioned on the first conductivity type semiconductor layer, a gate insulation layer positioned between the first conductivity type semiconductor layer and the gate electrode, a source electrode positioned on the second conductivity type doping well region, and a drain electrode positioned below the bottom surface of the substrate, wherein the source electrode includes, a first source electrode positioned on the gate electrode, a second source electrode positioned on the first source electrode, and a third source electrode positioned on the second source electrode, wherein the second source electrode has a greater electrical resistance than that of the first source electrode, and wherein the third source electrode has a greater electrical resistance than that of the second source electrode.

A semiconductor device according to another aspect includes a substrate comprising a cell region and a peripheral region positioned outside the cell region, a first conductivity type semiconductor layer positioned on the upper surface of the substrate, a second conductivity type doping well region positioned within the first conductivity type semiconductor layer, a gate electrode positioned on the first conductivity type semiconductor layer, a gate insulation layer positioned between the first conductivity type semiconductor layer and the gate electrode, a source electrode positioned on the second conductivity type doping well region, and a drain electrode positioned below the bottom surface of the substrate, wherein the source electrode includes, a first source electrode positioned on the gate electrode, and a second source electrode positioned on the first source electrode and having a greater electrical resistance than that of the first source electrode.

A manufacturing method of a semiconductor device according to one aspect includes forming a first conductivity type semiconductor layer on an upper surface of a substrate, forming a second conductivity type doping well region within the first conductivity type semiconductor layer, forming a gate insulation layer and a gate electrode on the first conductivity type semiconductor layer, forming a source electrode on the second conductivity type doping well region, and forming a drain electrode below a bottom surface of the substrate, wherein the source electrode is formed by forming a first source electrode on the gate electrode, forming a second interlayer insulating layer covering the first source electrode, etching the second interlayer insulating layer to expose the first source electrode, forming a resistance layer within the etched second interlayer insulating layer, and forming a second source electrode on the second interlayer insulating layer and the resistance layer, wherein the resistance layer is formed of a conductive material having a greater electrical resistance than that of the first source electrode.

The first source electrode may be formed to have a greater area in a first direction and a second direction, which intersect each other and are parallel to the upper surface of the substrate, than that of the cell region.

The second source electrode may be formed to have a smaller area in the first direction and second direction than that of the first source electrode.

The resistance layer may be formed to have a smaller area in the first direction and second direction than that of the first source electrode. The second source electrode and the resistance layer may be formed to be overlapped partially in the third direction.

The source electrode may be formed by forming the first source electrode on the gate electrode, forming the resistance layer on the first source electrode, forming the second interlayer insulating layer covering the first source electrode and the resistance layer, etching the second interlayer insulating layer to expose the resistance layer, and forming the second source electrode inside the etched second interlayer insulating layer. The resistance layer may include a conductive material having a greater electrical resistance than that of the first source electrode.

The source electrode may be formed by forming a first source electrode on the gate electrode, forming a first second interlayer insulating layer covering the first source electrode, etching the first second interlayer insulating layer to expose the first source electrode, forming a first resistance layer inside the etched first second interlayer insulating layer, forming a first third interlayer insulating layer on the first second interlayer insulating layer and the first resistance layer, etching the first third interlayer insulating layer to expose the first resistance layer, forming a first second source electrode inside the etched first third interlayer insulating layer, forming a second second interlayer insulating layer covering the first second source electrode, etching the second second interlayer insulating layer to expose the first second source electrode, forming a second resistance layer inside the etched second second interlayer insulating layer, forming a second third interlayer insulating layer on the second second interlayer insulating layer and the second resistance layer, etching the second third interlayer insulating layer to expose the second resistance layer, and forming a second second source electrode inside the etched second third interlayer insulating layer, and the second source electrodes are formed. The electrical resistance of the second source electrodes may increase as they are positioned higher in the third direction. the electrical resistance of the resistance layers may increase as they are positioned higher in the third direction.

A manufacturing method of a semiconductor device according to another aspect includes forming a first conductivity type semiconductor layer on an upper surface of a substrate, forming a second conductivity type doping well region within the first conductivity type semiconductor layer, forming a gate insulation layer and a gate electrode on the first conductivity type semiconductor layer, forming a source electrode on the second conductivity type doping well region, and forming a drain electrode below a bottom surface of the substrate, wherein the source electrode is formed by forming a first source electrode on the gate electrode, forming a second source electrode on the first source electrode, and forming a third source electrode on the second source electrode, wherein the second source electrode may have a greater electrical resistance than that of the first source electrode, and the third source electrode may have a greater electrical resistance than that of the second source electrode.

The source electrode may be formed by forming a first source electrode on a gate electrode, forming a second interlayer insulating layer covering the first source electrode, etching the second interlayer insulating layer to expose the first source electrode, forming a second source electrode inside the etched second interlayer insulating layer, and forming a third source electrode on the second interlayer insulating layer and the second source electrode.

A manufacturing method of a semiconductor device according to another aspect includes forming a first conductivity type semiconductor layer on an upper surface of a substrate, forming a second conductivity type doping well region within the first conductivity type semiconductor layer, forming a gate insulation layer and a gate electrode on the first conductivity type semiconductor layer, forming a source electrode on the second conductivity type doping well region, and forming a drain electrode below a bottom surface of the substrate, wherein the source electrode may be formed by forming a first source electrode on the gate electrode, forming a barrier layer covering the first source electrode, and forming the second source electrode on the barrier layer.

The source electrode may be formed by forming a first source electrode on a gate electrode, etching the first source electrode, forming a barrier layer inside the etched first source electrode, and forming a second source electrode inside the first source electrode on which the barrier layer has been formed.

Some implementations of the semiconductor devices described herein can prevent or reduce short-circuits by reducing saturation drain current (Idₛₐₜ) without changing the drain/source on-resistance (Rdsₒₙ), without changing the structure in the active source contact region, such as changing the channel length, and/or without adding additional resistance external to the circuit (e.g., package or module).

In addition, in some implementations, current spreading can be improved by reducing the current concentration of the active source contact and improving voltage overshooting or non-uniformity of the source current by cell region position.

At least some of the above and other features of the invention are set out in the claims.

### BRIEF DESCRIPTION OF THE DRAWINGS

FIG. 1 is a top plan view showing an example of a semiconductor device.
FIG. 2 is a cross-sectional view taken along line A-A' of FIG. 1.
FIG. 3 is a circuit diagram for an example of a semiconductor device.
FIG. 4 is a cross-sectional view showing an example of a semiconductor device corresponding to FIG. 2.
FIG. 5 is a cross-sectional view showing an example of a semiconductor device corresponding to FIG. 2.
FIG. 6 is a top plan view showing an example of a semiconductor device.
FIG. 7 is a cross-sectional view taken along line A-A' of FIG. 6.
FIG. 8 is a top plan view showing an example of a semiconductor device.
FIG. 9 is a cross-sectional view taken along line A-A' of FIG. 8.
FIG. 10 is a top plan view showing an example of a semiconductor device.
FIG. 11 is a cross-sectional view taken along line A-A' of FIG. 10.
FIG. 12 is a top plan view showing an example of a semiconductor device.
FIG. 13 is a cross-sectional view taken along line A-A' of FIG. 12.
FIG. 14 is a cross-sectional view showing an example of a semiconductor device corresponding to FIG. 13.

### DETAILED DESCRIPTION

Hereinafter, various examples according to the present disclosure will be described in detail with reference to the attached drawings so that a person having ordinary skill in the art to which the present disclosure pertains can easily implement the present disclosure. It will be understood that the present disclosure may be implemented in many different forms and is not limited to the specific examples set forth herein.

Like reference numerals designate like elements throughout the specification.

The size and thickness of constituent elements as shown in the drawings may be chosen for better understanding and ease of description, and this disclosure is not necessarily limited to the sizes and thicknesses shown. In the drawings, the thickness of layers, regions, etc., may be exaggerated for clarity. In addition, in the drawings, for better understanding and ease of description, the thickness of some layers and areas is exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. The word "on" or "above" means being disposed on or below the object portion, and does not necessarily mean being disposed on the upper side of the object portion based on a gravitational direction.

In addition, unless explicitly described to the contrary, the word "comprise," and variations such as "comprises" or "comprising," will be understood to imply the inclusion of stated elements but not the exclusion of any other elements.

In addition, in this specification, the phrase "on a plane" means viewing a target portion from the top, and the phrase "on a cross-section" means viewing a cross-section formed by vertically cutting a target portion from the side.

Additionally, throughout the specification, two directions parallel to the upper surface of the substrate are defined as a first direction D1 and a second direction D2, respectively, and the direction perpendicular to the upper surface of the substrate is described as a third direction D3. For example, the first direction D1 and the second direction D2 may be the length direction and the width direction, respectively, and the third direction D3 may be the thickness direction.

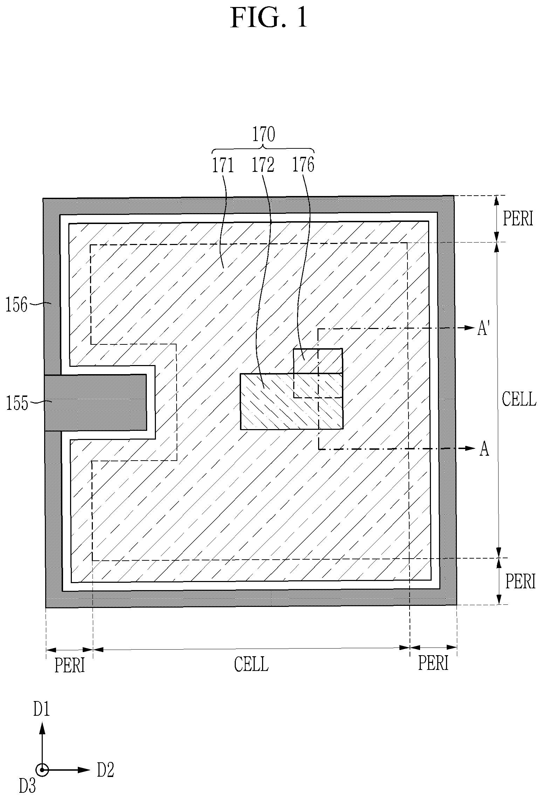

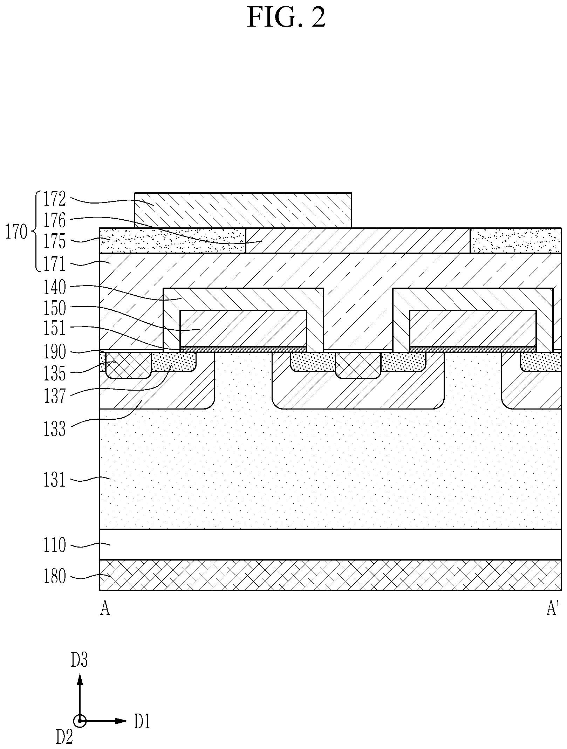

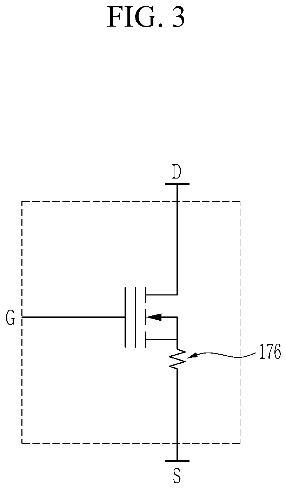

FIG. 1 is a top plan view showing a semiconductor device. FIG. 2 is a cross-sectional view taken along line A-A' of FIG. 1. FIG. 3 is a circuit diagram for a semiconductor device.

For clarity and simplicity of illustration, FIG. 1 mainly illustrates a first source electrode 171, a second source electrode 172, and a resistance layer 176 of a source electrode 170, a gate pad 155, and a gate wire 156.

Referring to FIGS. 1 to 3, a semiconductor device includes a substrate 110, a first conductivity type semiconductor layer 131 positioned on an upper surface of the substrate 110, a second conductivity type doping well region 133 positioned within the first conductivity type semiconductor layer 131, a gate electrode 150 positioned on the first conductivity type semiconductor layer 131 and the second conductivity type doping well region 133, a gate insulation layer 151 positioned between the first conductivity type semiconductor layer 131 and the gate electrode 150, a source electrode 170 positioned on the second conductivity type doping well region 133, and a drain electrode 180 positioned below a bottom surface of the substrate 110.

The substrate 110 may include a cell region CELL and a peripheral region PERI surrounding the cell region CELL.

The first source electrode 171 of the source electrode 170 described below may be positioned on the cell region CELL. The first source electrode 171 may cover the cell region CELL. For example, the cell region CELL may be completely overlapped with the first source electrode 171 in the third direction D3.

The gate pad 155 may be positioned on one side of the first source electrode 171 in the first direction D1 or second direction D2. For example, the gate pad 155 may be positioned in the peripheral region PERI. Additionally, a gate wire 156 extending from the gate pad 155 may be positioned in the peripheral region PERI. the gate wire 156 may be extended to be positioned throughout the peripheral region PERI. In other words, the gate wire 156 may surround the first source electrode 171.

The first source electrode 171 may be extended below the third direction D3 and make active source contact with the second conductivity type doping well region 133 described below. The gate pad 155 and the gate wire 156 may be electrically contacted to the gate electrode 150.

The semiconductor device can include a transistor. For example, the semiconductor device can be a power semiconductor device. Power semiconductor devices can be classified according to materials, and examples include SiC power semiconductor devices and GaN power semiconductor devices. Power semiconductor devices can be manufactured using SiC or GaN instead of existing silicon wafer (Si wafer), and thereby the disadvantage of silicon, which has unstable characteristics at high temperatures, can be compensated. The SiC power semiconductor devices are resistant to high temperatures and have low power loss, and can be suitable for electric vehicles, renewable energy systems, etc. The GaN power semiconductor devices require high costs, but are efficient in terms of speed and can be suitable for high-speed charging of mobile devices.

The substrate 110 may be a semiconductor substrate including SiC. For example, the substrate 110 may include a 4H SiC substrate. In some cases, the substrate 110 may include a 3C SiC substrate, or a 6H SiC substrate, etc. The substrate 110 may be doped by first conductivity type impurity. For example, the first conductivity type impurity may be n type impurity. In other words, the substrate 110 may be doped as n type. The substrate 110 may be highly doped as n type. The resistivity of the substrate 110 may be greater than or equal to 0.005 Ω·cm and less than or equal to 0.035 Ω·cm. The thickness of the substrate 110 may be greater than or equal to 10 µm and less than or equal to 700 µm. The material, doping type, doping concentration, resistivity, or thickness, etc. of the substrate 110 are not limited to this and may be changed in various ways. The substrate 110 may have a first surface and a second surface facing each other. The first surface of the substrate 110 may be an upper surface of the substrate 110, and the second surface of the substrate 110 may be a bottom surface of the substrate 110.

The first conductivity type semiconductor layer 131 may be positioned on the first surface, i.e., the upper surface, of the substrate 110. The bottom surface of the first conductivity type semiconductor layer 131 may be in contact with the upper surface of the substrate 110. However, the layer arrangements are not limited thereto, and another layer may be positioned between the substrate 110 and the first conductivity type semiconductor layer 131. The first conductivity type semiconductor layer 131 may be an epitaxial layer formed from the substrate 110 using an epitaxial growth method. The first conductivity type semiconductor layer 131 may include SiC. For example, the first conductivity type semiconductor layer 131 may include 4H SiC. The first conductivity type semiconductor layer 131 may be doped as n type. The first conductivity type semiconductor layer 131 may be lightly doped as n type. The doping concentration of the first conductivity type semiconductor layer 131 may be lower than the doping concentration of the substrate 110. The doping concentration of the first conductivity type semiconductor layer 131 may be greater than or equal to 1×10¹⁵ cm⁻³ and less than or equal to 1×10¹⁷ cm⁻³. The thickness of the first conductivity type semiconductor layer 131 may be greater than or equal to 1 µm and less than or equal to 13 µm. The material, doping type, doping concentration, etc. of the first conductivity type semiconductor layer 131 are not limited to this and may be changed in various ways.

The second conductivity type doping well region 133 may be positioned within the first conductivity type semiconductor layer 131. The second conductivity type doping well region 133 may be positioned on top of the first conductivity type semiconductor layer 131. The second conductivity type doping well region 133 may be in contact with the bottom surface of the second conductivity type doping layer 135 described below. The second conductivity type doping well region 133 may surround the bottom surface and side surface of the first conductivity type doping layer 137 described below.

At least a portion of the upper surface of the second conductivity type doping well region 133 may be overlapped with at least a portion of the gate electrode 150 described below and at least a portion of the gate insulation layer 151 described below in the third direction D3.

The second conductivity type doping well region 133 may extend from the upper surface of the first conductivity type semiconductor layer 131 in the bottom surface direction of the first conductivity type semiconductor layer 131. For example, the second conductivity type doping well region 133 may extend in the third direction D3 from the upper surface of the first conductivity type semiconductor layer 131. The second conductivity type doping well region 133 may be formed in at least some regions of the first conductivity type semiconductor layer 131 through ion implantation.

The second conductivity type doping well region 133 may include SiC. For example, the second conductivity type doping well region 133 may include 4H SiC. The second conductivity type doping well region 133 may be doped as p type. The second conductivity type doping well region 133 may be lightly doped as p type. The doping concentration of the second conductivity type doping well region 133 may be greater than or equal to 1×10¹⁷ cm⁻³ and less than or equal to 1×10¹⁹ cm⁻³. The material, doping type, doping concentration, etc. of the second conductivity type doping well region 133 are not limited to this and may be changed in various ways.

The semiconductor device may further include a second conductivity type doping layer 135 and a first conductivity type doping layer 137 positioned on top of the first conductivity type semiconductor layer 131.

The second conductivity type doping layer 135 may be positioned within the second conductivity type doping well region 133. The second conductivity type doping layer 135 may be positioned on top of the first conductivity type semiconductor layer 131 and may have an upper surface that is in direct contact with the bottom surface of the silicide layer 190 connected to the source electrode 170.

At least some region of the upper surface of the second conductivity type doping layer 135 may be in contact with the bottom surface of the silicide layer 190, but the arrangement is not limited thereto. For example, at least some region of the upper surface of the second conductivity type doping layer 135 may be in contact with the bottom surface of the source electrode 170. The second conductivity type doping layer 135 may have a width wider than the width of the source electrode 170.

The second conductivity type doping layer 135 may extend in the third direction D3 from the upper surface of the first conductivity type semiconductor layer 131. The thickness in the third direction D3 of the second conductivity type doping layer 135 may be smaller than the thickness in the third direction D3 of the second conductivity type doping well region 133. Additionally, the second conductivity type doping layer 135 may have a narrower width than that of the second conductivity type doping well region 133. For example, the second conductivity type doping layer 135 may be buried within the second conductivity type doping well region 133. The second conductivity type doping layer 135 may be formed in at least some regions of the second conductivity type doping well region 133 through ion implantation.

The second conductivity type doping layer 135 may include SiC. For example, the second conductivity type doping layer 135 may include 4H SiC. The second conductivity type doping layer 135 may be doped as p type. The second conductivity type doping layer 135 may form an ohmic contact with the source electrode 170. For this purpose, the second conductivity type doping layer 135 may be highly doped as p type. In some implementations, the doping concentration of the second conductivity type doping layer 135 may be higher than the doping concentration of the second conductivity type doping well region 133. The doping concentration of the second conductivity type doping layer 135 may be greater than or equal to 1×10¹⁸ cm⁻³ and less than or equal to 5×10²⁰ cm⁻³. The material, doping type, doping concentration, etc. of the second conductivity type doping layer 135 are not limited to this and may be changed in various ways.

The first conductivity type doping layer 137 may be positioned within the second conductivity type doping well region 133. The first conductivity type doping layer 137 may be positioned on top of the first conductivity type semiconductor layer 131 and may surround both lateral sides of the second conductivity type doping layer 135. The upper surface of the first conductivity type doping layer 137 may be overlapped with at least a part of the gate electrode 150 and at least a part of the gate insulation layer 151 in the third direction D3. In addition, the upper surface of the first conductivity type doping layer 137 may be overlapped with at least a part of the source electrode 170 described below in the third direction D3, but the arrangement is not limited thereto. The upper surface of the first conductivity type doping layer 137 may directly contact the gate insulation layer 151.

The first conductivity type doping layer 137 may extend in the third direction D3 from the upper surface of the first conductivity type semiconductor layer 131. The first conductivity type doping layer 137 may be buried within the second conductivity type doping well region 133. The thickness in the third direction D3 of the first conductivity type doping layer 137 may be smaller than the thickness in the third direction D3 of the second conductivity type doping well region 133.

The first conductivity type doping layer 137 may be a doping region formed using an ion implantation process in the first conductivity type semiconductor layer 131. The first conductivity type doping layer 137 may include SiC. For example, the first conductivity type doping layer 137 may include 4H SiC. The first conductivity type doping layer 137 may be doped as n type. The first conductivity type doping layer 137 may be highly doped as n type. The doping concentration of the first conductivity type doping layer 137 may be greater than or equal to 1×10¹⁸ cm⁻³ and less than or equal to 5×10²⁰ cm⁻³. The material, doping type, doping concentration, etc. of the first conductivity type doping layer 137 are not limited to this and may be changed in various ways.

The gate electrode 150 may be positioned on the first conductivity type semiconductor layer 131. The gate electrode 150 may be spaced apart from the first conductivity type semiconductor layer 131. For example, the gate electrode 150 may be spaced apart from the first conductivity type semiconductor layer 131 in the vertical direction (e.g., third direction D3) by a gate insulation layer 151. In some implementations, the semiconductor device may have a planar gate structure. For example, in the semiconductor device, the gate electrode 150 has a flat plate shape with a top surface and a bottom surface, and the bottom surface of the gate electrode 150 may be positioned at a level higher than that of the top surface of the first conductivity type semiconductor layer 131. However, the shape is not limited to this, and the semiconductor device may have, for example, a trench-shaped gate structure. For example, in a semiconductor device, a trench of a predetermined depth is formed in a first conductivity type semiconductor layer 131, and a gate electrode 150 may be positioned inside the trench so as to be spaced apart from the first conductivity type semiconductor layer 131 in the third direction D3. Additionally, the gate electrode 150 may be positioned apart from the first conductivity type semiconductor layer 131 in the first direction D1 and/or second direction D2. The gate electrode 150 may be overlapped with the second conductivity type doping well region 133 and the first conductivity type doping layer 137 in the third direction D3.

The gate electrode 150 may include conductive material. For example, the gate electrode 150 may include polysilicon doped with impurity. As another example, the gate electrode 150 may include a metal, a metal alloy, a conductive metal nitride, a metal silicide, a doped semiconductor material, a conductive metal oxide, a conductive metal oxynitride, or a combination thereof. The gate electrode 150 may consist of a single layer or multiple layers.

The gate insulation layer 151 may be positioned between the first conductivity type semiconductor layer 131 and the gate electrode 150. For example, the gate insulation layer 151 may be positioned below the third direction D3 of the gate electrode 150 and cover the bottom surface of the gate electrode 150. The gate electrode 150 may be insulated from the first conductivity type semiconductor layer 131 by the gate insulation layer 151. The thickness of gate insulation layer 151 may be constant.

The gate insulation layer 151 may be overlapped with the second conductivity type doping well region 133 and the first conductivity type doping layer 137 in the third direction D3. The bottom surface of the gate insulation layer 151 may directly contact the second conductivity type doping well region 133 and the first conductivity type doping layer 137, but the arrangement is not limited thereto.

The gate insulation layer 151 may include an insulating material. For example, the gate insulation layer 151 may include SiO₂. However, it is not limited to this, and the material of the gate insulation layer 151 may be changed in various ways. As another example, the gate insulation layer 151 may include SiN, SiON, SiC, SiCN, or a combination thereof. The gate insulation layer 151 may consist of a single layer or multiple layers.

The first interlayer insulating layer 140 may be positioned on the first conductivity type semiconductor layer 131. For example, the first interlayer insulating layer 140 may be positioned on the gate electrode 150. For example, the first interlayer insulating layer 140 may cover the upper surface and side surface of the gate electrode 150. The first interlayer insulating layer 140 may cover the side of the gate insulation layer 151. The first interlayer insulating layer 140 may also be positioned on the first conductivity type doping layer 137. The first interlayer insulating layer 140 may have a bottom surface in contact with at least a portion of the upper surface of the first conductivity type doping layer 137. The gate electrode 150 may be insulated from the source electrode 170 by the first interlayer insulating layer 140.

The first interlayer insulating layer 140 may include an insulating material. For example, the first interlayer insulating layer 140 may include the same insulating material as the gate insulation layer 151. For example, the first interlayer insulating layer 140 may include SiO₂. However, the material is not limited thereto, and the first interlayer insulating layer 140 may include various types of insulating materials to insulate the gate electrode 150 from the source electrode 170. For example, the first interlayer insulating layer 140 may include SiOP, SiN, SiON, or a combination thereof. The first interlayer insulating layer 140 may consist of a single layer or multiple layers. When the first interlayer insulating layer 140 is made of the same material as the gate insulation layer 151, the boundary between the first interlayer insulating layer 140 and the gate insulation layer 151 may not be clearly distinguished at the part where the first interlayer insulating layer 140 and the gate insulation layer 151 come into contact.

The source electrode 170 may be positioned on the second conductivity type doping well region 133. The second conductivity type doping layer 135 and the first conductivity type doping layer 137 may be positioned between the source electrode 170 and the second conductivity type doping well region 133. The source electrode 170 may be electrically connected to the second conductivity type doping well region 133 by the second conductivity type doping layer 135. Through the source electrode 170, current or voltage may be provided to the cell region CELL.

The source electrode 170 may include a first source electrode 171 and a second source electrode 172.

The first source electrode 171 may be positioned on the second conductivity type doping well region 133. The first source electrode 171 may be positioned on either side of the gate electrode 150. However, the arrangement is not limited to this, and the first source electrode 171 may be positioned only on one side of the gate electrode 150. The first source electrode 171 may be positioned on the gate electrode 150.

A first interlayer insulating layer 140 may be positioned between the first source electrode 171 and the gate electrode 150. The first source electrode 171 may be spaced apart from the gate electrode 150 by the first interlayer insulating layer 140. The first source electrode 171 may be in contact with the side and upper surfaces of the first interlayer insulating layer 140.

For example, the first source electrode 171 may have a portion positioned between different portions of the gate electrode 150 (and/or arranged laterally with respect to the gate electrode 150) and a portion positioned on the gate electrode 150. The portion positioned between different portions of the gate electrode 150 and/or arranged laterally with respect to the gate electrode 150 is referred to hereafter as a second portion of the gate electrode 150.

The portion of the first source electrode 171 positioned on the gate electrode 150 may be positioned on the cell region CELL. The portion of the first source electrode 171 positioned on the gate electrode 150 may cover the cell region CELL.

The portion of the first source electrode 171 positioned on the gate electrode 150 may have a greater area in the first direction D1 and second direction D2 (a lateral area) than that of the cell region CELL, on a plane extending in the first direction D1 and second direction D2 and perpendicular to the third direction D3, e.g., in FIG. 1. For example, the portion of the first source electrode 171 positioned on the gate electrode 150 may be overlapped only partially by the cell region CELL in the third direction D3, but the cell region CELL may be completely overlapped by the portion of the first source electrode 171 positioned on the gate electrode 150 in the third direction D3.

The second portion of the first source electrode 171 may be positioned on both sides of the gate electrode 150. The second portion of the first source electrode 171 may be surrounded laterally by the gate electrode 150 with the first interlayer insulating layer 140 interposed therebetween.

However, the arrangement of the second portion of the first source electrode 171 is not limited to this, and the second portion of the first source electrode 171 may be positioned only on one side of the gate electrode 150.

The second portion of the first source electrode 171 may be a portion extending, from the portion positioned on the gate electrode 150 of the first source electrode 171, downward in the third direction D3 toward the second conductivity type doping well region 133. The second portion of the first source electrode 171 may extend downward in the third direction D3 and may make an active source contact with the second conductivity type doping well region 133. The second portion of the first source electrode 171 may be overlapped with the second conductivity type doping layer 135 and the first conductivity type doping layer 137 in the third direction D3. However, the arrangement is not limited thereto, and the second portion of the first source electrode 171 may not be overlapped with the first conductivity type doping layer 137 in the third direction D3. The upper surface of the first conductivity type doping layer 137 may be covered by the gate insulation layer 151.

For example, the first source electrode 171 may include tungsten (W), aluminum (Al), copper (Cu), cobalt (Co), titanium (Ti), nickel (Ni), platinum (Pt), nickel platinum (Ni-Pt), niobium(Nb), niobium nitride(NbN), niobium carbide(NbC), molybdenum(Mo), molybdenum nitride (MoN), molybdenum carbide (MoC), tungsten carbide (WC), rhodium (Rh), ruthenium (Ru), iridium (Ir), osmium (Os), silver (Ag), gold (Au), zinc (Zn), vanadium(V), titanium aluminum(TiAl), titanium aluminum carbonitride(TiAIC-N), titanium aluminum carbide(TiAIC), titanium carbide(TiC), titanium nitride(TiN), titanium silicon nitride(TiSiN), titanium aluminum nitride (TiAIN), tungsten nitride (WN), or a combination thereof, but is not limited thereto. The first source electrode 171 may consist of a single layer or multiple layers.

The second source electrode 172 is positioned on the first source electrode 171.

For example, the second source electrode 172 may be positioned on the central portion of the upper surface of the first source electrode 171. The second source electrode 172 is electrically connected to the first source electrode 171, and an externally supplied source voltage may be applied to the first source electrode 171 through the second source electrode 172.

The second source electrode 172 may have a smaller area in the first direction D1 and the second direction D2 (a lateral area) than that of the first source electrode 171 on a plane, for example, as shown in FIG. 1. For example, the first source electrode 171 may be only partially overlapped by the second source electrode 172 in the third direction D3, but the second source electrode 172 may be completely overlapped by the first source electrode 171 in the third direction D3.

The second source electrode 172 may have a greater electrical resistance than that of the first source electrode 171. For example, the second source electrode 172 may have an electrical resistance that is greater than or equal to 10 times greater than that of the first source electrode 171, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, greater than or equal to 90 times greater, greater than or equal to 100 times greater, greater than or equal to 200 times greater, greater than or equal to 300 times greater, greater than or equal to 400 times greater, greater than or equal to 500 times greater, greater than or equal to 600 times greater, greater than or equal to 700 times greater, greater than or equal to 800 times greater, greater than or equal to 900 times greater, greater than or equal to 1000 times greater, greater than or equal to 2000 times greater, greater than or equal to 3000 times greater, greater than or equal to 4000 times greater, greater than or equal to 5000 times greater, greater than or equal to 6000 times greater, greater than or equal to 7000 times greater, greater than or equal to 8000 times greater, greater than or equal to 9000 times greater, or greater than or equal to 10000 times greater, and less than or equal to 10000 times greater, for example, less than or equal to 9000 times greater, less than or equal to 8000 times greater, less than or equal to 7000 times greater, less than or equal to 6000 times greater, less than or equal to 5000 times greater, less than or equal to 4000 times greater, less than or equal to 3000 times greater, less than or equal to 2000 times greater, less than or equal to 1000 times greater, less than or equal to 900 times greater, less than or equal to 800 times greater, less than or equal to 700 times greater, less than or equal to 600 times greater, less than or equal to 500 times greater, less than or equal to 400 times greater, less than or equal to 300 times greater, less than or equal to 200 times greater, less than or equal to 100 times greater, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples may be greater than or equal to 10 times greater and less than or equal to 10000 times greater.

For example, the electrical resistance of the first source electrode 171 may be greater than or equal to 1.0×10⁻⁸ Ω m at 0 °C, for example, greater than or equal to 2.0×10⁻⁸ Ω m, greater than or equal to 3.0×10⁻⁸ Ω m, greater than or equal to 4.0×10⁻⁸ Ω m, greater than or equal to 5.0×10⁻⁸ Ω m, greater than or equal to 6.0×10⁻⁸ Ω m, greater than or equal to 7.0×10⁻⁸ Ω m, greater than or equal to 8.0×10⁻⁸ Ω m, or greater than or equal to 9.0×10⁻⁸ Ω m, and less than or equal to 10.0×10⁻⁸ Ω m, for example, less than or equal to 9.0×10⁻⁸ Ω m, less than or equal to 8.0×10⁻⁸ Ω m, less than or equal to 7.0×10⁻⁸ Ω m, less than or equal to 6.0×10⁻⁸ Ω m, less than or equal to 5.0×10⁻⁸ Ω m, less than or equal to 4.0×10⁻⁸ Ω m, less than or equal to 3.0×10⁻⁸ Ω m, or less than or equal to 2.0×10⁻⁸ Ω m, and may be greater than or equal to 1.0×10⁻⁸ Ω m and less than or equal to 10.0×10⁻⁸ Ω m.

The electrical resistance of the second source electrode 172 may be greater than 10.0×10⁻⁸ Ω m at 0 °C, for example, greater than or equal to 20.0×10⁻⁸ Ω m, greater than or equal to 30.0×10⁻⁸ Ω m, greater than or equal to 40.0×10⁻⁸ Ω m, greater than or equal to 50.0×10⁻⁸ Ω m, greater than or equal to 60.0×10⁻⁸ Ω m, greater than or equal to 70.0×10⁻⁸ Ω m, greater than or equal to 80.0×10⁻⁸ Ω m, greater than or equal to 90.0×10⁻⁸ Ω m, greater than or equal to 100.0×10⁻⁸ Ω m, greater than or equal to 200.0×10⁻⁸ Ω m, greater than or equal to 300.0×10⁻⁸ Ω m, greater than or equal to 400.0×10⁻⁸ Ω m, greater than or equal to 500.0×10⁻⁸ Ω m, greater than or equal to 600.0×10⁻⁸ Ω m, greater than or equal to 700.0×10⁻⁸ Ω m, greater than or equal to 800.0×10⁻⁸ Ω m, or greater than or equal to 900.0×10⁻⁸ Ω m, and less than or equal to 1000.0×10⁻⁸ Ω m, for example less than or equal to 900.0×10⁻⁸ Ω m, less than or equal to 800.0×10⁻⁸ Ω m, less than or equal to 700.0×10⁻⁸ Ω m, less than or equal to 600.0×10⁻⁸ Ω m, less than or equal to 500.0×10⁻⁸ Ω m, less than or equal to 400.0×10⁻⁸ Ω m, less than or equal to 300.0×10⁻⁸ Ω m, less than or equal to 200.0×10⁻⁸ Ω m, less than or equal to 100.0×10⁻⁸ Ω m, less than or equal to 90.0×10⁻⁸ Ω m, less than or equal to 80.0×10⁻⁸ Ω m, less than or equal to 70.0×10⁻⁸ Ω m, less than or equal to 60.0×10⁻⁸ Ω m, less than or equal to 50.0×10⁻⁸ Ω m, less than or equal to 40.0×10⁻⁸ Ω m, less than or equal to 30.0×10⁻⁸ Ω m, or less than or equal to 20.0×10⁻⁸ Ω m, and in some examples may be greater than or equal to 10.0×10⁻⁸ Ω m and less than or equal to 1000.0×10⁻⁸ Ω m, or greater than or equal to 100.0×10⁻⁸ Ω m and less than or equal to 1000.0×10⁻⁸ Ω m.

For example, the electrical resistance of the first source electrode 171 and the second source electrode 172 may be measured by the TLM (transmission line measurement) analysis method. For example, TLM analysis may be performed using MaxScience JVL equipment. According to TLM analysis, the electrical resistance value may be measured according to the length of the first source electrode 171 or second source electrode 172.

For example, the second source electrode 172 may include, without being limited to this, a material having a higher electrical resistance than that of the first source electrode 171. For example, the second source electrode 172 may include palladium (Pd), tin (Sn), tantalum (Ta), chromium (Cr), strontium (St), antimony (Sb), zirconium (Zr), rubidium (Rb), manganese (Mn), polysilicon (polysilicon), tantalum carbonitride (TaCN), tantalum carbide (TaC), tantalum nitride (TaN), tantalum silicon nitride (TaSiN), tantalum titanium nitride (TaTiN), tantalum aluminum nitride (TaAIN), or a combination thereof, and may consist of a single layer or multiple layers.

For example, the thickness of the second source electrode 172 may be greater than or equal to 10 nm, for example, greater than or equal to 20 nm, greater than or equal to 30 nm, greater than or equal to 40 nm, greater than or equal to 50 nm, greater than or equal to 60 nm, greater than or equal to 70 nm, greater than or equal to 80 nm, greater than or equal to 90 nm, greater than or equal to 100 nm, greater than or equal to 200 nm, greater than or equal to 300 nm, greater than or equal to 400 nm, greater than or equal to 500 nm, greater than or equal to 600 nm, greater than or equal to 700 nm, greater than or equal to 800 nm, greater than or equal to 900 nm, greater than or equal to 1 µm, greater than or equal to 2 µm, greater than or equal to 3 µm, greater than or equal to 4 µm, greater than or equal to 5 µm, greater than or equal to 6 µm, greater than or equal to 7 µm, greater than or equal to 8 µm, or greater than or equal to 9 µm, and may be less than or equal to 10 µm, for example, less than or equal to 9 µm, less than or equal to 8 µm, less than or equal to 7 µm, less than or equal to 6 µm, less than or equal to 5 µm, less than or equal to 4 µm, less than or equal to 3 µm, less than or equal to 2 µm, less than or equal to 1 µm, less than or equal to 900 nm, less than or equal to 800 nm, less than or equal to 700 nm, less than or equal to 600 nm, less than or equal to 500 nm, less than or equal to 400 nm, less than or equal to 300 nm, less than or equal to 200 nm, less than or equal to 100 nm, less than or equal to 90 nm, less than or equal to 80 nm, less than or equal to 70 nm, less than or equal to 60 nm, less than or equal to 50 nm, less than or equal to 40 nm, less than or equal to 30 nm, or less than or equal to 20 nm, and may be greater than or equal to 10 nm and less than or equal to 10 µm. Here, the thickness of the second source electrode 172 may be a shortest distance in the third direction D3 from the bottom surface to the upper surface of the second source electrode 172 in a cross-section cut in the first direction D1 and the third direction D3 and perpendicular to the second direction D2, e.g., FIG. 2.

The source electrode 170 may further include a resistance layer 176 between the first source electrode 171 and the second source electrode 172. For example, the first source electrode 171, the resistance layer 176, and the second source electrode 172 may be sequentially stacked in the third direction D3.

The first source electrode 171 may be electrically connected to the second source electrode 172 through the resistance layer 176. For example, the first source electrode 171 and the second source electrode 172, may not make direct contact, and may be spaced apart from each other in the third direction D3 with the resistance layer 176 between them.

The resistance layer 176 may have a smaller area in the first direction D1 and the second direction D2 (a lateral area) than that of the first source electrode 171 on a plane, e.g., FIG. 1. For example, the first source electrode 171 may be only partially overlapped with the resistance layer 176 in the third direction D3, but the resistance layer 176 may be completely overlapped by the first source electrode 171 in the third direction D3.

The resistance layer 176 may have an area smaller, larger, or the same in the first direction D1 and the second direction D2 (a lateral area) than that of the second source electrode 172 on a plane, e.g., FIG. 1. Additionally, the second source electrode 172 and the resistance layer 176 may be partially overlapped by each other in the third direction D3.

The resistance layer 176 may have a greater electrical resistance than that of the first source electrode 171. Additionally, the resistance layer 176 may have an electrical resistance less than or equal to that of the second source electrode 172.

For example, the resistance layer 176 may have an electrical resistance that is greater than or equal to 10 times greater than that of the first source electrode 171, for example greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and less than or equal to 100 times greater, for example less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and greater than or equal to 10 times greater and less than or equal to 100 times greater.

The second source electrode 172 may have an electrical resistance that is greater than or equal to 10 times greater than that of the resistance layer 176, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and may be less than or equal to 100 times greater, for example, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples may be greater than or equal to 10 times greater and less than or equal to 100 times greater.

For example, the electrical resistance of the resistance layer 176 may be greater than 10.0×10⁻⁸ Ω m at 0 °C, for example, greater than or equal to 20.0×10⁻⁸ Ω m, greater than or equal to 30.0×10⁻⁸ Ω m, greater than or equal to 40.0×10⁻⁸ Ω m, greater than or equal to 50.0×10⁻⁸ Ω m, greater than or equal to 60.0×10⁻⁸ Ω m, greater than or equal to 70.0×10⁻⁸ Ω m, greater than or equal to 80.0×10⁻⁸ Ω m, or greater than or equal to 90.0×10⁻⁸ Ω m, and less than 100.0×10⁻⁸ Ω m, for example, less than or equal to 90.0×10⁻⁸ Ω m, less than or equal to 80.0×10⁻⁸ Ω m, less than or equal to 70.0×10⁻⁸ Ω m, less than or equal to 60.0×10⁻⁸ Ω m, less than or equal to 50.0×10⁻⁸ Ω m, less than or equal to 40.0×10⁻⁸ Ω m, less than or equal to 30.0×10⁻⁸ Ω m, or less than or equal to 20.0×10⁻⁸ Ω m, and in some examples may be greater than 10.0×10⁻⁸ Ω m and less than 100.0×10⁻⁸ Ω m.

For example, the electrical resistance of the resistance layer 176 may be measured by the TLM (transmission line measurement) analysis method. For example, TLM analysis may be performed using MaxScience JVL equipment. According to TLM analysis, the electrical resistance value may be measured according to the length of the resistance layer 176.

For example, the resistance layer 176 may include, without being limited to this, a conductive material having a greater electrical resistance (or resistivity) than that of the first source electrode 171. For example, the resistance layer 176 may include palladium (Pd), tin (Sn), tantalum (Ta), chromium (Cr), strontium (St), antimony (Sb), zirconium (Zr), rubidium (Rb), manganese (Mn), polysilicon, tantalum carbonitride (TaCN), tantalum carbide (TaC), tantalum nitride (TaN), tantalum silicon nitride (TaSiN), tantalum titanium nitride (TaTiN), tantalum aluminum nitride (TaAIN), or a combination thereof, and may consist of a single layer or multiple layers.

For example, when the resistance layer 176 includes polysilicon, the electrical resistance of the polysilicon may be controlled from greater than 10.0×10⁻⁸ Ω·m and less than 100.0×10⁻⁸ Ω·m at 0 °C, depending on the type and concentration of the doping element.

For example, the thickness of the resistance layer 176 may be greater than or equal to 10 nm, for example, greater than or equal to 20 nm, greater than or equal to 30 nm, greater than or equal to 40 nm, greater than or equal to 50 nm, greater than or equal to 60 nm, greater than or equal to 70 nm, greater than or equal to 80 nm, greater than or equal to 90 nm, greater than or equal to 100 nm, greater than or equal to 200 nm, greater than or equal to 300 nm, greater than or equal to 400 nm, greater than or equal to 500 nm, greater than or equal to 600 nm, greater than or equal to 700 nm, greater than or equal to 800 nm, greater than or equal to 900 nm, greater than or equal to 1 µm, greater than or equal to 2 µm, greater than or equal to 3 µm, greater than or equal to 4 µm, greater than or equal to 5 µm, greater than or equal to 6 µm, greater than or equal to 7 µm, greater than or equal to 8 µm, or greater than or equal to 9 µm, and may be less than or equal to 10 µm, for example, less than or equal to 9 µm, less than or equal to 8 µm, less than or equal to 7 µm, less than or equal to 6 µm, less than or equal to 5 µm, less than or equal to 4 µm, less than or equal to 3 µm, less than or equal to 2 µm, less than or equal to 1 µm, less than or equal to 900 nm, less than or equal to 800 nm, less than or equal to 700 nm, less than or equal to 600 nm, less than or equal to 500 nm, less than or equal to 400 nm, less than or equal to 300 nm, less than or equal to 200 nm, less than or equal to 100 nm, less than or equal to 90 nm, less than or equal to 80 nm, less than or equal to 70 nm, less than or equal to 60 nm, less than or equal to 50 nm, less than or equal to 40 nm, less than or equal to 30 nm, or less than or equal to 20 nm, and in some examples may be greater than or equal to 10 nm and less than or equal to 10 µm. Here, the thickness of the resistance layer 176 may be the shortest distance in the third direction D3 from the bottom surface to the upper surface of the resistance layer 176 in a cross-section cut in the first direction D1 and the third direction D3 and perpendicular to the second direction D2, e.g., FIG. 2.

The second interlayer insulating layer 175 may be positioned on the first source electrode 171. The second interlayer insulating layer 175 may cover the upper surface of the first source electrode 171. Additionally, the second interlayer insulating layer 175 may cover the side surface of the resistance layer 176.

For example, the second interlayer insulating layer 175 may be positioned between the first source electrode 171 and the second source electrode 172. The first source electrode 171 and the second source electrode 172 may be separated from each other by the second interlayer insulating layer 175, and the first source electrode 171 and the second source electrode 172 may be electrically connected to each other through the resistance layer 176.

A level in the third direction D3 of the upper surface of the second interlayer insulating layer 175 may be the same as a level in the third direction D3 of the upper surface of the resistance layer 176. For example, the upper surface of the second interlayer insulating layer 175 and the upper surface of the resistance layer 176 may form coplanar surfaces. The resistance layer 176 may be positioned within the second interlayer insulating layer 175, and the second source electrode 172 may be positioned on the second interlayer insulating layer 175.

The second interlayer insulating layer 175 may include an insulating material. For example, the second interlayer insulating layer 175 may include SiO₂. However, the material is not limited thereto, and the second interlayer insulating layer 175 may include various types of insulating materials for insulating the first source electrode 171 and the second source electrode 172. For example, the second interlayer insulating layer 175 may include SiOP, SiN, SiON, or a combination thereof. The second interlayer insulating layer 175 may consist of a single layer or multiple layers.

In SiC electric power semiconductor devices, there is a method of controlling the current to prevent a short circuit. In this case, the resistance of the channel, etc. increases, so the drain/source on-state resistance (Rdsₒₙ) increases. Accordingly, the channel length may be reduced to reduce Rdsₒₙ. However, changing the channel length requires an increase in current, which causes a loss of saturation drain current (Idₛₐₜ). Therefore, it is desirable to prevent short-circuits while maintaining Rdsₒₙ and reducing Idₛₐₜ.

Some implementations of the semiconductor device described herein, such as that of FIGS. 1-3, include the source electrode 170 including the first source electrode 171 positioned on a gate electrode 150, and the second source electrode 172 positioned on the first source electrode 171 and having a greater electrical resistance than that of the first source electrode 171. In another example, the source electrode 170 can include the resistance layer 176 positioned between the first source electrode 171 and the second source electrode 172 and including a conductive material having a greater electrical resistance (or resistivity) than that of the first source electrode 171.

For example, the source electrode 170 includes at least one of the second source electrode 172 or the resistance layer 176, which has a higher electrical resistance as it is positioned higher in the third direction D3 in the active source contact region where the source electrode 170 contacts the second conductivity type doping well region 133.

Accordingly, as shown in the circuit diagram of FIG. 3, the gate pad 155 on the gate G side makes direct contact with the metal, but the current entering from the source S side is supplied through the second source electrode 172 and/or the resistance layer 176, which has high electrical resistance. In this way, if the local resistance in the current path on the source S side is increased, a large amount of current flows due to the ballast resistance principle, and the potential difference between the gate G and the source S is reduced due to the voltage drop. When the potential difference between the gate G and source S decreases, the channel is closed, and the current is limited to prevent a short-circuit.

Therefore, the short-circuit can be prevented or reduced by reducing Idₛₐₜ without necessarily changing Rdₛₒₙ and without necessarily changing the structure in the active source contact region, such as changing the channel length, without necessarily adding additional resistance outside the circuit, e.g., package or module.

In addition, the second source electrode 172 and/or the resistance layer 176 positioned on the upper portion of the source electrode 170 may have relatively high electrical resistance, and the first source electrode 171 positioned on the bottom portion of the source electrode 170 and making an active source contact may have relatively low electrical resistance, and the area of the first source electrode 171 may be relatively wide compared to the area of the second source electrode 172 and/or the resistance layer 176, so that the current concentration of the active source contact may be reduced, and voltage overshooting or non-uniformity of the source current by cell region CELL position may be reduced, thereby improving current spreading.

For example, a semiconductor device may be manufactured by forming a first conductivity type semiconductor layer 131 on an upper surface of a substrate 110, forming a second conductivity type doping well region 133 within the first conductivity type semiconductor layer 131, forming a gate insulation layer 151 and a gate electrode 150 on the first conductivity type semiconductor layer 131, forming a source electrode 170 on the second conductivity type doping well region 133, and forming a drain electrode 180 below the bottom surface of the substrate 110. The source electrode 170 may be formed by forming a first source electrode 171 on a gate electrode 150, forming a second interlayer insulating layer 175 covering the first source electrode 171, etching the second interlayer insulating layer 175 to expose the first source electrode 171, forming a resistance layer 176 within the etched second interlayer insulating layer 175, and forming a second source electrode 172 on the second interlayer insulating layer 175 and the resistance layer 176. The resistance layer 176 may be formed of a material including a conductive material having a greater electrical resistance (or resistivity) than that of the first source electrode 171.

Additionally, the first source electrode 171 may be formed to have a greater area in the first direction D1 and the second direction D2 than that of the cell region CELL. The second source electrode 172 may be formed to have a smaller area in the first direction D1 and second direction D2 than that of the first source electrode 171. The resistance layer 176 has a smaller area in the first direction D1 and second direction D2 than that of the first source electrode 171, and the second source electrode 172 and the resistance layer 176 may be formed so that they are overlapped only partially in the third direction D3.

The semiconductor device may further include a silicide layer 190 positioned between the source electrode 170 and the second conductivity type doping layer 135 and between the source electrode 170 and the first conductivity type doping layer 137.

The silicide layer 190 may be conformally positioned along the interface between the source electrode 170 and the second conductivity type doping layer 135 and between the source electrode 170 and the first conductivity type doping layer 137. The bottom surface of the silicide layer 190 may directly contact the second conductivity type doping layer 135 and the first conductivity type doping layer 137. The upper surface of the silicide layer 190 may be in direct contact with the source electrode 170. The silicide layer 190 may include a metal silicide material. For example, the silicide layer 190 may include tungsten silicide (WSi), titanium silicide (TiSi), cobalt silicide (CoSi), nickel silicide (NiSi), or a combination thereof.

In the manufacturing process, a silicide layer 190 may be formed by performing a silicidation process on the upper surface of the second conductivity type doping layer 135 and the first conductivity type doping layer 137. However, the process is not limited thereto, and, as another example, after forming the source electrode 170, a subsequent annealing process may be performed to reduce the contact resistance between the second conductivity type doping layer 135 and the source electrode 170 and between the first conductivity type doping layer 137 and the source electrode 170. Accordingly, the silicide layer 190 may be formed along the interface between the source electrode 170 and the second conductivity type doping layer 135 and between the source electrode 170 and the first conductivity type doping layer 137.

The drain electrode 180 may be positioned below the second surface of the substrate 110, i.e., the bottom surface. The upper surface of the drain electrode 180 may be in contact with the bottom surface of the substrate 110. The drain electrode 180 may be in ohmic contact with the substrate 110. The region in contact with the drain electrode 180 within the substrate 110 may be doped at a relatively high concentration compared to other regions. However, the configuration is not limited to this, and another predetermined layer may be positioned between the drain electrode 180 and the substrate 110. For example, a silicide layer may be positioned between the drain electrode 180 and the substrate 110. The silicide layer may include a metal silicide material. The metal silicide layer enables smooth electrical connection between the drain electrode 180 and the substrate 110.

The drain electrode 180 may include conductive material. For example, the drain electrode 180 may include a metal, a metal alloy, a conductive metal nitride, a metal silicide, a doped semiconductor material, a conductive metal oxide, or a conductive metal oxynitride. The drain electrode 180 may include the same material as the source electrode 170, or may include a different material.

For example, the drain electrode 180 may be titanium (Ti), titanium nitride (TiN), titanium silicon nitride (TiSiN), titanium aluminum nitride (TiAIN), titanium carbide (TiC), titanium aluminum (TiAl), titanium aluminum carbonitride (TiAIC-N), titanium aluminum carbide (TiAIC), tantalum (Ta), tantalum carbide (TaC), tantalum nitride (TaN), tantalum carbonitride (TaCN), tantalum silicon nitride (TaSiN), tantalum titanium nitride (TaTiN), tantalum aluminum nitride (TaAIN), tungsten (W), tungsten nitride (WN), tungsten carbide (WC), aluminum (Al), copper (Cu), cobalt (Co), nickel (Ni), nickel vanadium (Ni-V), nickel platinum (Ni-Pt), vanadium (V), zinc (Zn), niobium (Nb), niobium nitride (NbN), niobium carbide (NbC), molybdenum (Mo), molybdenum nitride (MoN), molybdenum carbide (MoC), ruthenium (Ru), platinum (Pt), rhodium (Rh), palladium (Pd), iridium (Ir), osmium (Os), silver (Ag), gold (Au), or a combination thereof, but is not limited thereto. The source electrode 170 may consist of a single layer or multiple layers. The drain electrode 180 may consist of a single layer or multiple layers.

For example, the thickness of the drain electrode 180 may be greater than or equal to 100 nm, for example, greater than or equal to 1 µm, greater than or equal to 2 µm, greater than or equal to 3 µm, greater than or equal to 4 µm, greater than or equal to 5 µm, greater than or equal to 6 µm, greater than or equal to 7 µm, greater than or equal to 8 µm, or greater than or equal to 9 µm, and may be less than or equal to 10 µm, for example, less than or equal to 9 µm, less than or equal to 8 µm, less than or equal to 7 µm, less than or equal to 6 µm, less than or equal to 5 µm, less than or equal to 4 µm, less than or equal to 3 µm, less than or equal to 2 µm, or less than or equal to 1 µm, and in some examples may be greater than or equal to 100 nm and less than or equal to 10 µm, or greater than or equal to 100 nm and less than or equal to 3 µm.

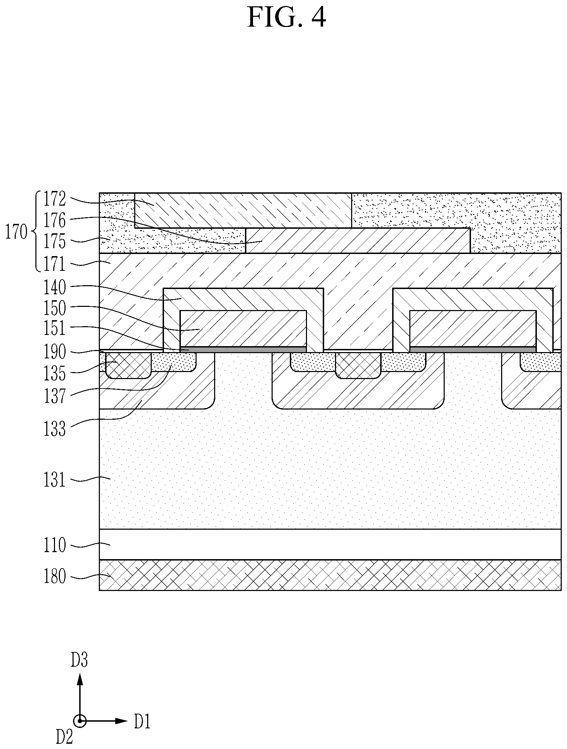

Hereinafter, examples of semiconductor devices will be described with reference to FIG. 4 to FIG. 14.

FIG. 4 is a cross-sectional view showing a semiconductor device corresponding to FIG. 2. The example illustrated in FIG. 4 is substantially identical or similar to the example illustrated in FIG. 2, and thus overlapping description thereof will be omitted and the differences will be mainly explained. Additionally, the same reference numerals are used for the same components.

Referring to FIG. 4, the second interlayer insulating layer 175 may be positioned on the first source electrode 171. The second interlayer insulating layer 175 may cover the upper surface of the first source electrode 171. The second interlayer insulating layer 175 may cover the upper surface and side surfaces of the resistance layer 176. Additionally, the second interlayer insulating layer 175 may cover the side surface of the second source electrode 172.

A level in the third direction D3 of the upper surface of the second interlayer insulating layer 175 may be higher than a level in the third direction D3 of the upper surface of the resistance layer 176. Accordingly, the second interlayer insulating layer 175 may cover the upper surface of the resistance layer 176, and the resistance layer 176 may be positioned within the second interlayer insulating layer 175.

A level in the third direction D3 of the upper surface of the second interlayer insulating layer 175 may be the same as a level in the third direction D3 of the upper surface of the second source electrode 172. In other words, the upper surface of the second interlayer insulating layer 175 and the upper surface of the second source electrode 172 may form coplanar surfaces. Accordingly, the second source electrode 172 may be positioned within the second interlayer insulating layer 175.

For example, a semiconductor device may be manufactured by forming a first conductivity type semiconductor layer 131 on an upper surface of a substrate 110, forming a second conductivity type doping well region 133 within the first conductivity type semiconductor layer 131, forming a gate insulation layer 151 and a gate electrode 150 on the first conductivity type semiconductor layer 131, forming a source electrode 170 on the second conductivity type doping well region 133, and forming a drain electrode 180 below the bottom surface of the substrate 110. The source electrode 170 may form a resistance layer 176 on a first source electrode 171, form a second interlayer insulating layer 175 covering the first source electrode 171 and the resistance layer 176, etch the second interlayer insulating layer 175 to expose a portion of the resistance layer 176, and then form a second source electrode 172 inside the etched second interlayer insulating layer 175. The second interlayer insulating layer 175 may also serve as a passivation layer.

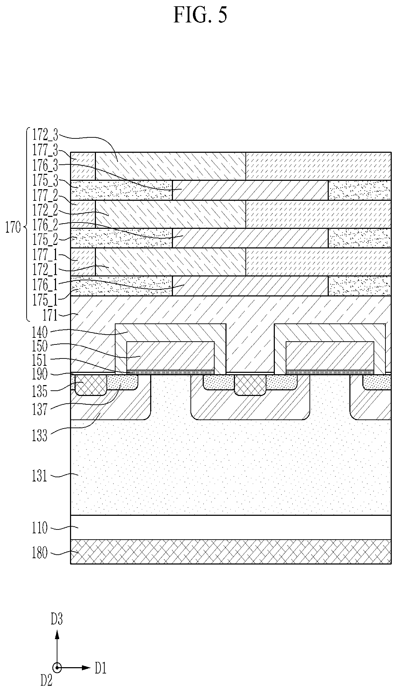

FIG. 5 is a cross-sectional view showing a semiconductor device corresponding to FIG. 2. The example illustrated in FIG. 5 is substantially identical or similar to the example illustrated in FIG. 2, and thus overlapping description thereof will be omitted and the differences will be mainly explained. Additionally, the same reference numerals are used for the same components.

Referring to FIG. 5, the source electrode 170 may include a plurality of the second source electrodes 172_1, 172_2, 172_3 and a plurality of the resistance layers 176_1, 176_2, 176_3. A plurality of the second source electrodes 172_1, 172_2, 172_3 and a plurality of the resistance layers 176_1, 176_2, 176_3 may be alternately stacked in the third direction D3.

As an example, FIG. 5 illustrates that the source electrode 170 includes three layers of second source electrodes 172_1, 172_2, 172_3 and three layers of resistance layers 176_1, 176_2, 176_3. In other words, the source electrode 170 may include a first resistance layer 176_1 positioned on the first source electrode 171, a first second source electrode 172_1 positioned on the first resistance layer 176_1, a second resistance layer 176_2 positioned on the first second source electrode 172_1, a second second source electrode 172_2 positioned on the second resistance layer 176_2, a third resistance layer 176_3 positioned on the second second source electrode 172_2, and a third second source electrode 172_3 positioned on the third resistance layer 176_3.

However, the layer configuration is not limited thereto, and the source electrode 170 may include the second source electrode 172 in greater than or equal to 2 layers, for example, greater than or equal to 3 layers, greater than or equal to 4 layers, greater than or equal to 5 layers, greater than or equal to 6 layers, greater than or equal to 7 layers, greater than or equal to 8 layers, greater than or equal to 9 layers, greater than or equal to 10 layers, greater than or equal to 20 layers, greater than or equal to 30 layers, greater than or equal to 40 layers, greater than or equal to 50 layers, greater than or equal to 60 layers, greater than or equal to 70 layers, greater than or equal to 80 layers, or greater than or equal to 90 layers, and may include less than or equal to 100 layers, for example, less than or equal to 90 layers, less than or equal to 80 layers, less than or equal to 70 layers, less than or equal to 60 layers, less than or equal to 50 layers, less than or equal to 40 layers, less than or equal to 30 layers, less than or equal to 20 layers, less than or equal to 10 layers, less than or equal to 9 layers, less than or equal to 8 layers, less than or equal to 7 layers, less than or equal to 6 layers, less than or equal to 5 layers, less than or equal to 4 layers, less than or equal to 3 layers, or less than or equal to 2 layers, and in some examples greater than or equal to 2 layers and less than or equal to 100 layers. However, if the number of layers of the second source electrode 172 is too great, cracks or stress may occur in the second interlayer insulating layer 175 during scribing.

In addition, the source electrode 170 may include the resistance layer 176 in greater than or equal to 2 layers, for example, greater than or equal to 3 layers, greater than or equal to 4 layers, greater than or equal to 5 layers, greater than or equal to 6 layers, greater than or equal to 7 layers, greater than or equal to 8 layers, greater than or equal to 9 layers, greater than or equal to 10 layers, greater than or equal to 20 layers, greater than or equal to 30 layers, greater than or equal to 40 layers, greater than or equal to 50 layers, greater than or equal to 60 layers, greater than or equal to 70 layers, greater than or equal to 80 layers, or greater than or equal to 90 layers, and may include less than or equal to 100 layers, for example, less than or equal to 90 layers, less than or equal to 80 layers, less than or equal to 70 layers, less than or equal to 60 layers, less than or equal to 50 layers, less than or equal to 40 layers, less than or equal to 30 layers, less than or equal to 20 layers, less than or equal to 10 layers, less than or equal to 9 layers, less than or equal to 8 layers, less than or equal to 7 layers, less than or equal to 6 layers, less than or equal to 5 layers, less than or equal to 4 layers, less than or equal to 3 layers, or less than or equal to 2 layers, and in some examples may include greater than or equal to 2 layers and less than or equal to 100 layers. However, if the number of layers of the resistance layer 176 is too great, cracks or stress may occur in the second interlayer insulating layer 175 during scribing.

The electrical resistance of a plurality of the second source electrodes 172_1, 172_2, 172_3 may be increased as they are positioned higher in the third direction D3. For example, the second second source electrode 172_2 may have an electrical resistance that is greater than or equal to 10 times greater than that of the first second source electrode 172_1, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, greater than or equal to 90 times greater, greater than or equal to 100 times greater, greater than or equal to 200 times greater, greater than or equal to 300 times greater, greater than or equal to 400 times greater, greater than or equal to 500 times greater, greater than or equal to 600 times greater, greater than or equal to 700 times greater, greater than or equal to 800 times greater, greater than or equal to 900 times greater, greater than or equal to 1000 times greater, greater than or equal to 2000 times greater, greater than or equal to 3000 times greater, greater than or equal to 4000 times greater, greater than or equal to 5000 times greater, greater than or equal to 6000 times greater, greater than or equal to 7000 times greater, greater than or equal to 8000 times greater, greater than or equal to 9000 times greater, or greater than or equal to 10000 times greater, and less than or equal to 10000 times greater, for example, less than or equal to 9000 times greater, less than or equal to 8000 times greater, less than or equal to 7000 times greater, less than or equal to 6000 times greater, less than or equal to 5000 times greater, less than or equal to 4000 times greater, less than or equal to 3000 times greater, less than or equal to 2000 times greater, less than or equal to 1000 times greater, less than or equal to 900 times greater, less than or equal to 800 times greater, less than or equal to 700 times greater, less than or equal to 600 times greater, less than or equal to 500 times greater, less than or equal to 400 times greater, less than or equal to 300 times greater, less than or equal to 200 times greater, less than or equal to 100 times greater, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples greater than or equal to 10 times greater and less than or equal to 10000 times greater.

In addition, the third second source electrode 172_3 may have an electrical resistance that is greater than or equal to 10 times greater than that of the second second source electrode 172_2, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, greater than or equal to 90 times greater, greater than or equal to 100 times greater, greater than or equal to 200 times greater, greater than or equal to 300 times greater, greater than or equal to 400 times greater, greater than or equal to 500 times greater, greater than or equal to 600 times greater, greater than or equal to 700 times greater, greater than or equal to 800 times greater, greater than or equal to 900 times greater, greater than or equal to 1000 times greater, greater than or equal to 2000 times greater, greater than or equal to 3000 times greater, greater than or equal to 4000 times greater, greater than or equal to 5000 times greater, greater than or equal to 6000 times greater, greater than or equal to 7000 times greater, greater than or equal to 8000 times greater, greater than or equal to 9000 times greater, or greater than or equal to 10000 times greater, and less than or equal to 10000 times greater, for example, less than or equal to 9000 times greater, less than or equal to 8000 times greater, less than or equal to 7000 times greater, less than or equal to 6000 times greater, less than or equal to 5000 times greater, less than or equal to 4000 times greater, less than or equal to 3000 times greater, less than or equal to 2000 times greater, less than or equal to 1000 times greater, less than or equal to 900 times greater, less than or equal to 800 times greater, less than or equal to 700 times greater, less than or equal to 600 times greater, less than or equal to 500 times greater, less than or equal to 400 times greater, less than or equal to 300 times greater, less than or equal to 200 times greater, less than or equal to 100 times greater, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples may be greater than or equal to 10 times greater and less than or equal to 10000 times greater.

The electrical resistance of a plurality of the resistance layers 176_1, 176_2, 176_3 may be increased as they are positioned higher in the third direction D3. For example, the second resistance layer 176_2 may have an electrical resistance that is greater than or equal to 10 times greater than that of the first resistance layer 176_1, for example greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, greater than or equal to 90 times greater, greater than or equal to 100 times greater, greater than or equal to 200 times greater, greater than or equal to 300 times greater, greater than or equal to 400 times greater, greater than or equal to 500 times greater, greater than or equal to 600 times greater, greater than or equal to 700 times greater, greater than or equal to 800 times greater, greater than or equal to 900 times greater, greater than or equal to 1000 times greater, greater than or equal to 2000 times greater, greater than or equal to 3000 times greater, greater than or equal to 4000 times greater, greater than or equal to 5000 times greater, greater than or equal to 6000 times greater, greater than or equal to 7000 times greater, greater than or equal to 8000 times greater, greater than or equal to 9000 times greater, or greater than or equal to 10000 times greater, and less than or equal to 10000 times greater, for example, less than or equal to 9000 times greater, less than or equal to 8000 times greater, less than or equal to 7000 times greater, less than or equal to 6000 times greater, less than or equal to 5000 times greater, less than or equal to 4000 times greater, less than or equal to 3000 times greater, less than or equal to 2000 times greater, less than or equal to 1000 times greater, less than or equal to 900 times greater, less than or equal to 800 times greater, less than or equal to 700 times greater, less than or equal to 600 times greater, less than or equal to 500 times greater, less than or equal to 400 times greater, less than or equal to 300 times greater, less than or equal to 200 times greater, less than or equal to 100 times greater, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples may be greater than or equal to 10 times greater and less than or equal to 10000 times greater.

Additionally, the third resistance layer 176_3 may have an electrical resistance that is greater than or equal to 10 times greater than that of the second resistance layer 176_2, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, greater than or equal to 90 times greater, greater than or equal to 100 times greater, greater than or equal to 200 times greater, greater than or equal to 300 times greater, greater than or equal to 400 times greater, greater than or equal to 500 times greater, greater than or equal to 600 times greater, greater than or equal to 700 times greater, greater than or equal to 800 times greater, greater than or equal to 900 times greater, greater than or equal to 1000 times greater, greater than or equal to 2000 times greater, greater than or equal to 3000 times greater, greater than or equal to 4000 times greater, greater than or equal to 5000 times greater, greater than or equal to 6000 times greater, greater than or equal to 7000 times greater, greater than or equal to 8000 times greater, greater than or equal to 9000 times greater, or greater than or equal to 10000 times greater, and may be less than or equal to 10000 times greater, for example, less than or equal to 9000 times greater, less than or equal to 8000 times greater, less than or equal to 7000 times greater, less than or equal to 6000 times greater, less than or equal to 5000 times greater, less than or equal to 4000 times greater, less than or equal to 3000 times greater, less than or equal to 2000 times greater, less than or equal to 1000 times greater, less than or equal to 900 times greater, less than or equal to 800 times greater, less than or equal to 700 times greater, less than or equal to 600 times greater, less than or equal to 500 times greater, less than or equal to 400 times greater, less than or equal to 300 times greater, less than or equal to 200 times greater, less than or equal to 100 times greater, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples may be greater than or equal to 10 times greater and less than or equal to 10000 times greater.

For example, the first resistance layer 176_1 may have a greater electrical resistance than that of the first source electrode 171, and the first second source electrode 172_1 may have a greater electrical resistance than that of the first resistance layer 176_1. The second resistance layer 176_2 may have a greater electrical resistance than that of the first second source electrode 172_1, and the second second source electrode 172_2 may have a greater electrical resistance than that of the second resistance layer 176_2. The third resistance layer 176_3 may have a greater electrical resistance than that of the second source electrode 172_2, and the third second source electrode 172_3 may have a greater electrical resistance than that of the third resistance layer 176_3.

For example, the first resistance layer 176_1 may have an electrical resistance that is greater than or equal to 10 times greater than that of the first source electrode 171, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and less than or equal to 100 times greater, for example, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples greater than or equal to 10 times greater and less than or equal to 100 times greater.

Additionally, each of the second source electrodes 172_1, 172_2, 172_3 may have an electrical resistance that is greater than or equal to 10 times greater than that of each of the resistance layers 176_1, 176_2, 176_3 positioned directly below them in the third direction D3, for example, greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and may be less than or equal to 100 times greater, for example, less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples may be greater than or equal to 10 times greater and less than or equal to 100 times greater.

The source electrode 170 may further include a plurality of the second interlayer insulating layers 175_1, 175_2, 175_3 and a plurality of the third interlayer insulating layers 177_1, 177_2, 177_3.

The second interlayer insulating layers 175_1, 175_2, 175_3 may cover the side surfaces of the resistance layers 176_1, 176_2, 176_3, respectively. Additionally, a level in the third direction D3 of the upper surfaces of the second interlayer insulating layers 175_1, 175_2, 175_3 may be the same as a level in the third direction D3 of the upper surfaces of the resistance layers 176_1, 176_2, 176_3, respectively. In other words, the upper surfaces of the multi-layer second interlayer insulating layers 175_1, 175_2, 175_3 and the upper surfaces of the multi-layer resistance layers 176_1, 176_2, 176_3 may form coplanar surfaces. Accordingly, the multi-layer resistance layers 176_1, 176_2, 176_3 may be positioned within the multi-layer second interlayer insulating layers 175_1, 175_2, 175_3, respectively.

For example, the first resistance layer 176_1 may be positioned within the first second interlayer insulating layer 175_1, the second resistance layer 176_2 may be positioned within the second second interlayer insulating layer 175_2, and the third resistance layer 176_3 may be positioned within the third second interlayer insulating layer 175_3.

The third interlayer insulating layers 177_1, 177_2, 177_3 may cover the side surfaces of the second source electrodes 172_1, 172_2, 172_3, respectively. In addition, a level in the third direction D3 of the upper surfaces of the third interlayer insulating layers 177_1, 177_2, 177_3 may be the same as a level in the third direction D3 of the upper surfaces of the second source electrodes 172_1, 172_2, 172_3, respectively. In other words, the upper surfaces of the third interlayer insulating layers 177_1, 177_2, 177_3 and the upper surfaces of the second source electrodes 172_1, 172_2, 172_3 may form coplanar surfaces. Accordingly, the second source electrodes 172_1, 172_2, 172_3 may be positioned within the third interlayer insulating layers 177_1, 177_2, 177_3, respectively.

For example, the first second source electrode 172_1 may be positioned within the first third interlayer insulating layer 177_1, the second second source electrode 172_2 may be positioned within the second third interlayer insulating layer 177_2, and the third second source electrode 172_3 may be positioned within the third third interlayer insulating layer 177_3.

The third interlayer insulating layers 177_1, 177_2, 177_3 may include an insulating material. For example, the third interlayer insulating layers 177_1, 177_2, 177_3 may include SiO₂. However, it is not limited thereto, and the third interlayer insulating layers 177_1, 177_2, 177_3 may include SiOP, SiN, SiON, or a combination thereof. The third interlayer insulating layers 177_1, 177_2, 177_3 may consist of a single layer or multiple layers, respectively.

For example, a semiconductor device may be manufactured by forming a first conductivity type semiconductor layer 131 on an upper surface of a substrate 110, forming a second conductivity type doping well region 133 within the first conductivity type semiconductor layer 131, forming a gate insulation layer 151 and a gate electrode 150 on the first conductivity type semiconductor layer 131, forming a source electrode 170 on the second conductivity type doping well region 133, and forming a drain electrode 180 below the bottom surface of the substrate 110. The source electrode 170 may be formed by forming a first source electrode 171 on the gate electrode 150, forming a first second interlayer insulating layer 175_1 covering the first source electrode 171, etching the first second interlayer insulating layer 175_1 to expose the first source electrode 171, forming a first resistance layer 176_1 inside the etched first second interlayer insulating layer 175_1, forming a first third interlayer insulating layer 177_1 on the first second interlayer insulating layer 175_1 and the first resistance layer 176_1, etching the first third interlayer insulating layer 177_1 to expose the first resistance layer 176_1, forming a first second source electrode 172_1 inside the etched first third interlayer insulating layer 177_1, forming a second second interlayer insulating layer 175_2 covering the first second source electrode 172_1, forming the second second interlayer insulating layer 175_2 covering the first second source electrode 172_1, etching to expose the first second source electrode 172_1, forming the second resistance layer 176_2 inside the etched second second interlayer insulating layer 175_2, forming the second third interlayer insulating layer 177_2 on the second second interlayer insulating layer 175_2 and the second resistance layer 176_2, etching the second third interlayer insulating layer 177_2 to expose the second resistance layer 176_2, and forming the second second source electrode 172_2 inside the etched second third interlayer insulating layer 177_2.

In addition, the source electrode 170 may be formed by forming a third second interlayer insulating layer 175_3 covering a second second source electrode 172_2, etching the third second interlayer insulating layer 175_3 to expose the second second source electrode 172_2, forming a third resistance layer 176_3 inside the etched third second interlayer insulating layer 175_3, forming the third third interlayer insulating layer 177_3 on the third second interlayer insulating layer 175_3 and the third resistance layer 176_3, etching the third third interlayer insulating layer 177_3 to expose the third resistance layer 176_3, and forming the third second source electrode 172_3 inside the etched third third interlayer insulating layer 177_3. The electrical resistance of the second source electrodes 172_1, 172_2, 172_3 may be increased as they are positioned higher in the third direction D3. Additionally, the electrical resistance of the resistance layers 176_1, 176_2, 176_3 may be increased as they are positioned higher in the third direction D3.

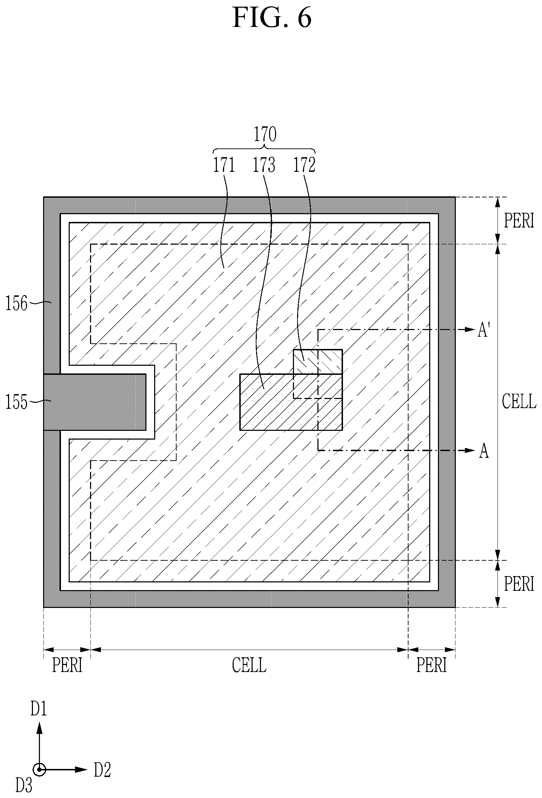

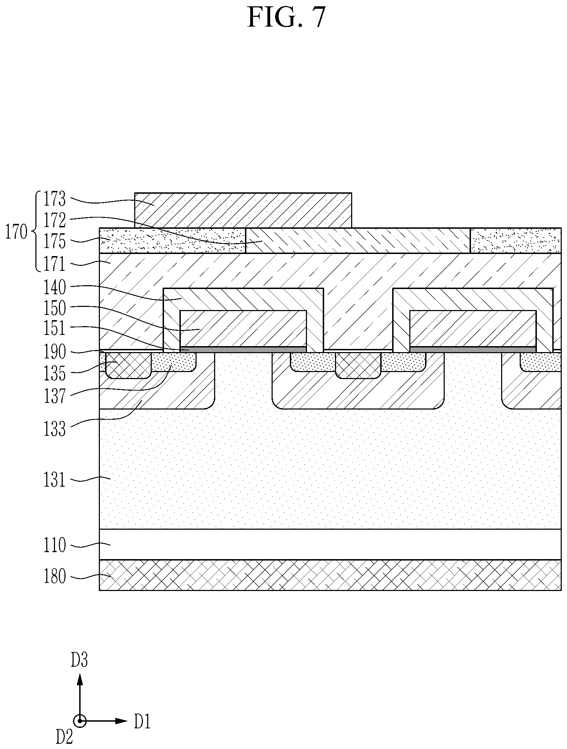

FIG. 6 is a top plan view showing an example of a semiconductor device. FIG. 7 is a cross-sectional view taken along line A-A' of FIG. 6.

The example and views illustrated in FIG. 6 and FIG. 7 are substantially identical or similar to the example and views illustrated in FIG. 1 and FIG. 2, and overlapping description thereof will be omitted and the differences will be mainly explained. Additionally, the same reference numerals are used for the same components.

Referring to FIG. 6 and FIG. 7, a source electrode 170 may include a first source electrode 171, a second source electrode 172, and a third source electrode 173. The second source electrode 172 may be positioned on the first source electrode 171, and the third source electrode 173 may be positioned on the second source electrode 172.

The second source electrode 172 may be positioned between the first source electrode 171 and the third source electrode 173. In other words, the first source electrode 171, the second source electrode 172, and the third source electrode 173 may be sequentially stacked in the third direction D3.

The first source electrode 171 may be electrically connected to the third source electrode 173 through the second source electrode 172. In other words, the first source electrode 171 and the third source electrode 173 may not make direct contact, and may be spaced apart from each other in the third direction D3 with the second source electrode 172 between them.

The second source electrode 172 may have a smaller area in the first direction D1 and second direction D2 than that of the first source electrode 171, on a plane extending in the first direction D1 and second direction D2 and perpendicular to the third direction D3, e.g., in FIG. 6. For example, the first source electrode 171 may be partially overlapped with the second source electrode 172 in the third direction D3, but the second source electrode 172 may be completely overlapped with the first source electrode 171 in the third direction D3.

The second source electrode 172 may have a greater electrical resistance than that of the first source electrode 171. Additionally, the second source electrode 172 may have a smaller electrical resistance than that of the third source electrode 173. For example, the second source electrode 172 may have an electrical resistance that is greater than or equal to 10 times greater than that of the first source electrode 171, for example greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and less than or equal to 100 times greater, for example less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples greater than or equal to 10 times greater and less than or equal to 100 times greater.

For example, the electrical resistance of the second source electrode 172 may be greater than or equal to 10.0×10⁻⁸ Ω m at 0 °C, for example, greater than or equal to 20.0×10⁻⁸ Ω m, greater than or equal to 30.0×10⁻⁸ Ω m, greater than or equal to 40.0×10⁻⁸ Ω m, greater than or equal to 50.0×10⁻⁸ Ω m, greater than or equal to 60.0×10⁻⁸ Ω m, greater than or equal to 70.0×10⁻⁸ Ω m, greater than or equal to 80.0×10⁻⁸ Ω m, or greater than or equal to 90.0×10⁻⁸ Ω m, and less than 100.0×10⁻⁸ Ω m, for example, less than or equal to 90.0×10⁻⁸ Ω m, less than or equal to 80.0×10⁻⁸ Ω m, less than or equal to 70.0×10⁻⁸ Ω m, less than or equal to 60.0×10⁻⁸ Ω m, less than or equal to 50.0×10⁻⁸ Ω m, less than or equal to 40.0×10⁻⁸ Ω m, less than or equal to 30.0×10⁻⁸ Ω m, or less than or equal to 20.0×10⁻⁸ Ω m, and in some examples may be greater than 10.0×10⁻⁸ Ω m and less than 100.0×10⁻⁸ Ω m.

For example, the second source electrode 172 may include, without being limited thereto, a conductive material having a greater electrical resistance (or resistivity) than that of the first source electrode 171. For example, the second source electrode 172 may include palladium (Pd), tin (Sn), tantalum (Ta), chromium (Cr), strontium (St), antimony (Sb), zirconium (Zr), rubidium (Rb), manganese (Mn), polysilicon, tantalum carbonitride (TaCN), tantalum carbide (TaC), tantalum nitride (TaN), tantalum silicon nitride (TaSiN), tantalum titanium nitride (TaTiN), tantalum aluminum nitride (TaAIN), or a combination thereof, and may consist of a single layer or multiple layers.

For example, when the second source electrode 172 includes polysilicon, the electrical resistance of the polysilicon may be controlled from greater than 10.0×10⁻⁸ Ω·m and less than 100.0×10⁻⁸ Ω·m at 0 °C, depending on the type and concentration of the doping element.

For example, the thickness of the second source electrode 172 may be greater than or equal to 10 nm, for example, greater than or equal to 20 nm, greater than or equal to 30 nm, greater than or equal to 40 nm, greater than or equal to 50 nm, greater than or equal to 60 nm, greater than or equal to 70 nm, greater than or equal to 80 nm, greater than or equal to 90 nm, greater than or equal to 100 nm, greater than or equal to 200 nm, greater than or equal to 300 nm, greater than or equal to 400 nm, greater than or equal to 500 nm, greater than or equal to 600 nm, greater than or equal to 700 nm, greater than or equal to 800 nm, greater than or equal to 900 nm, greater than or equal to 1 µm, greater than or equal to 2 µm, greater than or equal to 3 µm, greater than or equal to 4 µm, greater than or equal to 5 µm, greater than or equal to 6 µm, greater than or equal to 7 µm, greater than or equal to 8 µm, or greater than or equal to 9 µm, and may be less than or equal to 10 µm, for example, less than or equal to 9 µm, less than or equal to 8 µm, less than or equal to 7 µm, less than or equal to 6 µm, less than or equal to 5 µm, less than or equal to 4 µm, less than or equal to 3 µm, less than or equal to 2 µm, less than or equal to 1 µm, less than or equal to 900 nm, less than or equal to 800 nm, less than or equal to 700 nm, less than or equal to 600 nm, less than or equal to 500 nm, less than or equal to 400 nm, less than or equal to 300 nm, less than or equal to 200 nm, less than or equal to 100 nm, less than or equal to 90 nm, less than or equal to 80 nm, less than or equal to 70 nm, less than or equal to 60 nm, less than or equal to 50 nm, less than or equal to 40 nm, less than or equal to 30 nm, or less than or equal to 20 nm, and may be greater than or equal to 10 nm and less than or equal to 10 µm. Here, the thickness of the second source electrode 172 may be the shortest distance in the third direction D3 from the bottom surface to the upper surface of the second source electrode 172 in a cross-section cut in the first direction D1 and the third direction D3 and perpendicular to the second direction D2, e.g., FIG. 7.

The third source electrode 173 may be positioned on the second source electrode 172.

For example, the third source electrode 173 may be positioned on the central portion of the upper surface of the first source electrode 171. The third source electrode 173 is electrically connected to the first source electrode 171 through the second source electrode 172, and an externally supplied source voltage may be applied to the second source electrode 172 and the first source electrode 171 through the third source electrode 173.

The third source electrode 173 may have a smaller area in the first direction D1 and the second direction D2 than that of the first source electrode 171 on a plane, e.g., FIG. 6. For example, the first source electrode 171 may be partially overlapped by the third source electrode 173 in the third direction D3, but the third source electrode 173 may be completely overlapped by the first source electrode 171 in the third direction D3.

The second source electrode 172 may have a smaller, larger, or the same area in the first direction D1 and the second direction D2 than that of the third source electrode 173 on a plane, e.g., FIG. 6. Additionally, the second source electrode 172 and the third source electrode 173 may be only partially overlapped by each other in the third direction D3.

The third source electrode 173 may have a greater electrical resistance than that of the second source electrode 172.

For example, the third source electrode 173 may have an electrical resistance that is greater than or equal to 10 times greater than that of the electrical resistance of the second source electrode 172, for example greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and less than or equal to 100 times greater, for example less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and greater than or equal to 10 times greater and less than or equal to 100 times greater.

For example, the electrical resistance of the third source electrode 173 may be greater than or equal to 100.0×10⁻⁸ Ω m at 0 °C, for example, greater than or equal to 200.0×10⁻⁸ Ω m, greater than or equal to 300.0×10⁻⁸ Ω m, greater than or equal to 400.0×10⁻⁸ Ω m, greater than or equal to 500.0×10⁻⁸ Ω m, greater than or equal to 600.0×10⁻⁸ Ω m, greater than or equal to 700.0×10⁻⁸ Ω m, greater than or equal to 800.0×10⁻⁸ Ω m, or greater than or equal to 900.0×10⁻⁸ Ω m, and less than or equal to 1000.0×10⁻⁸ Ω m, for example, less than or equal to 900.0×10⁻⁸ Ω m, less than or equal to 800.0×10⁻⁸ Ω m, less than or equal to 700.0×10⁻⁸ Ω m, less than or equal to 600.0×10⁻⁸ Ω m, less than or equal to 500.0×10⁻⁸ Ω m, less than or equal to 400.0×10⁻⁸ Ω m, less than or equal to 300.0×10⁻⁸ Ω m, or less than or equal to 200.0×10⁻⁸ Ω m, and may be greater than or equal to 100.0×10⁻⁸ Ω m and less than or equal to 1000.0×10⁻⁸ Ω m.

For example, the third source electrode 173 may include, without being limited thereto, a material having a higher electrical resistance than that of the second source electrode 172. For example, the third source electrode 173 may include palladium (Pd), tin (Sn), tantalum (Ta), chromium (Cr), strontium (St), antimony (Sb), zirconium (Zr), rubidium (Rb), manganese (Mn), polysilicon, tantalum carbonitride (TaCN), tantalum carbide (TaC), tantalum nitride (TaN), tantalum silicon nitride (TaSiN), tantalum titanium nitride (TaTiN), tantalum aluminum nitride (TaAIN), or a combination thereof, and may consist of a single layer or multiple layers.

For example, the thickness of the third source electrode 173 may be greater than or equal to 10 nm, for example, greater than or equal to 20 nm, greater than or equal to 30 nm, greater than or equal to 40 nm, greater than or equal to 50 nm, greater than or equal to 60 nm, greater than or equal to 70 nm, greater than or equal to 80 nm, greater than or equal to 90 nm, greater than or equal to 100 nm, greater than or equal to 200 nm, greater than or equal to 300 nm, greater than or equal to 400 nm, greater than or equal to 500 nm, greater than or equal to 600 nm, greater than or equal to 700 nm, greater than or equal to 800 nm, greater than or equal to 900 nm, greater than or equal to 1 µm, greater than or equal to 2 µm, greater than or equal to 3 µm, greater than or equal to 4 µm, greater than or equal to 5 µm, greater than or equal to 6 µm, greater than or equal to 7 µm, greater than or equal to 8 µm, or greater than or equal to 9 µm, and may be less than or equal to 10 µm, for example, less than or equal to 9 µm, less than or equal to 8 µm, less than or equal to 7 µm, less than or equal to 6 µm, less than or equal to 5 µm, less than or equal to 4 µm, less than or equal to 3 µm, less than or equal to 2 µm, less than or equal to 1 µm, less than or equal to 900 nm, less than or equal to 800 nm, less than or equal to 700 nm, less than or equal to 600 nm, less than or equal to 500 nm, less than or equal to 400 nm, less than or equal to 300 nm, less than or equal to 200 nm, less than or equal to 100 nm, less than or equal to 90 nm, less than or equal to 80 nm, less than or equal to 70 nm, less than or equal to 60 nm, less than or equal to 50 nm, less than or equal to 40 nm, less than or equal to 30 nm, or less than or equal to 20 nm, and may be greater than or equal to 10 nm and less than or equal to 10 µm. Here, the thickness of the third source electrode 173 may be the shortest distance in the third direction D3 from the bottom surface to the upper surface of the third source electrode 173 in a cross-section cut in the first direction D1 and the third direction D3 and perpendicular to the second direction D2, e.g., FIG. 7.

The second interlayer insulating layer 175 may be positioned on the first source electrode 171. The second interlayer insulating layer 175 may cover the upper surface of the first source electrode 171. Additionally, the second interlayer insulating layer 175 may cover the side surface of the second source electrode 172.

For example, the second interlayer insulating layer 175 may be positioned between the first source electrode 171 and the third source electrode 173. The first source electrode 171 and the third source electrode 173 may be spaced apart from each other by the second interlayer insulating layer 175, and the first source electrode 171 and the third source electrode 173 may be electrically connected to each other through the second source electrode 172.

A level in the third direction D3 of the upper surface of the second interlayer insulating layer 175 may be the same as a level in the third direction D3 of the upper surface of the second source electrode 172. For example, the upper surface of the second interlayer insulating layer 175 and the upper surface of the second source electrode 172 may form coplanar surfaces. The second source electrode 172 may be positioned within the second interlayer insulating layer 175, and the third source electrode 173 may be positioned on the second interlayer insulating layer 175.

As shown in FIGS. 6-7, a semiconductor device may include a second source electrode 172 and a third source electrode 173, the electrical resistance of which increases upward in the third direction D3 from an active source contact region where the source electrode 170 contacts a second conductivity type doping well region 133.

According to this, as shown in the circuit diagram of FIG. 3, the gate pad 155 on the gate G side makes direct contact with the metal, but the current entering from the source S side is supplied through the second source electrode 172 and the third source electrode 173, which have high electrical resistance. In this way, if the local resistance in the current path on the source S side is increased, a large amount of current flows due to the ballast resistance principle, and the potential difference between the gate G and the source S is reduced due to the voltage drop. When the potential difference between the gate G and source S decreases, the channel is closed, and the current is limited to prevent short-circuit.

Therefore, the short-circuit can be prevented or reduced by reducing Idₛₐₜ without changing Rdsₒₙ and without necessarily changing the structure in the active source contact region, such as changing the channel length, without necessarily adding additional resistance outside the circuit, e.g., package or module.

In addition, the second source electrode 172 and the third source electrode 173 positioned on the first source electrode 171 have relatively high electrical resistance, and the first source electrode 171 positioned below the source electrode 170 and forming active source contact has relatively low electrical resistance, and the area of the first source electrode 171 is relatively wide compared to the areas of the second source electrode 172 and the third source electrode 173, so that the current concentration of the active source contact may be reduced, and the current spreading may be improved by reducing voltage overshooting or non-uniformity of the source current by cell region CELL position.

For example, a semiconductor device may be manufactured by forming a first conductivity type semiconductor layer 131 on an upper surface of a substrate 110, forming a second conductivity type doping well region 133 within the first conductivity type semiconductor layer 131, forming a gate insulation layer 151 and a gate electrode 150 on the first conductivity type semiconductor layer 131, forming a source electrode 170 on the second conductivity type doping well region 133, and forming a drain electrode 180 below the bottom surface of the substrate 110. The source electrode 170 is formed by forming a first source electrode 171 on the gate electrode 150, forming a second source electrode 172 on the first source electrode 171, forming a third source electrode 173 on the second source electrode 172. The second source electrode 171 may have a greater electrical resistance than that of the first source electrode 171, and the third source electrode 173 may have a greater electrical resistance than that of the second source electrode 172.

For example, the source electrode 170 may be formed by forming a first source electrode 171 on a gate electrode 150, forming a second interlayer insulating layer 175 covering the first source electrode 171, etching the second interlayer insulating layer 175 to expose the first source electrode 171, forming a second source electrode 172 within the etched second interlayer insulating layer 175, and forming a third source electrode 173 on the second interlayer insulating layer 175 and the second source electrode 172.

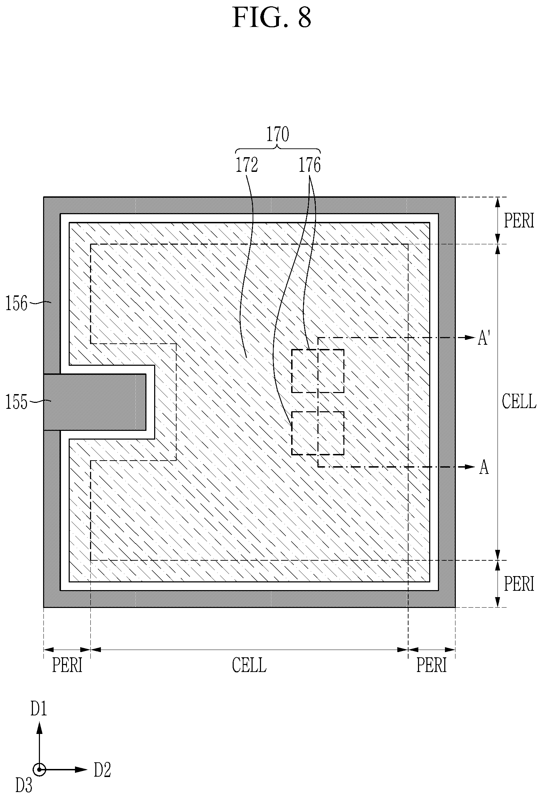

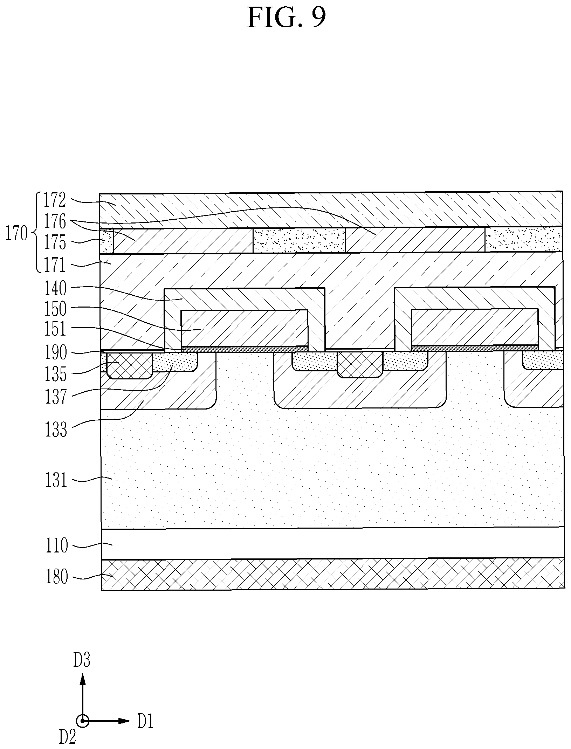

FIG. 8 is a top plan view showing an example of a semiconductor device. FIG. 9 is a cross-sectional view taken along line A-A' of FIG. 8.

The example and views illustrated in FIG. 8 and FIG. 9 are substantially identical or similar to the example and views illustrated in FIG. 1 and FIG. 2, and overlapping description thereof will be omitted and the differences will be mainly explained. Additionally, the same reference numerals are used for the same components.

Referring to FIG. 8 and FIG. 9, the second source electrode 172 may have a larger or the same area in the first direction D1 and the second direction D2 compared to that of the first source electrode 171, on a plane extending in the first direction D1 and second direction D2 and perpendicular to the third direction D3, e.g., in FIG. 8. For example, the second source electrode 172 may be partially or completely overlapped by the first source electrode 171 in the third direction D3.

Additionally, the second source electrode 172 may cover the cell region CELL. The second source electrode 172 may have a larger area in the first direction D1 and the second direction D2 than that of the cell region CELL on a plane, e.g., FIG. 8. For example, the second source electrode 172 may be partially overlapped with the cell region CELL in the third direction D3, but the cell region CELL may be completely overlapped by the second source electrode 172 in the third direction D3.

The resistance layer 176 may be positioned between the first source electrode 171 and the second source electrode 172, and a plurality of resistance layers 176 may be interposed between the first source electrode 171 and the second source electrode 172. For example, a plurality of resistance layers 176 may be spaced apart in the first direction D1 or the second direction D2 within the second interlayer insulating layer 175.

In this way, if the second source electrode 172 and the first source electrode 171 have similar areas in the first direction D1 and the second direction D2, and the resistance layer 176 is positioned at (e.g., only at) the connection portion between the second source electrode 172 and the first source electrode 171, current spreading may be improved from the second source electrode 172.

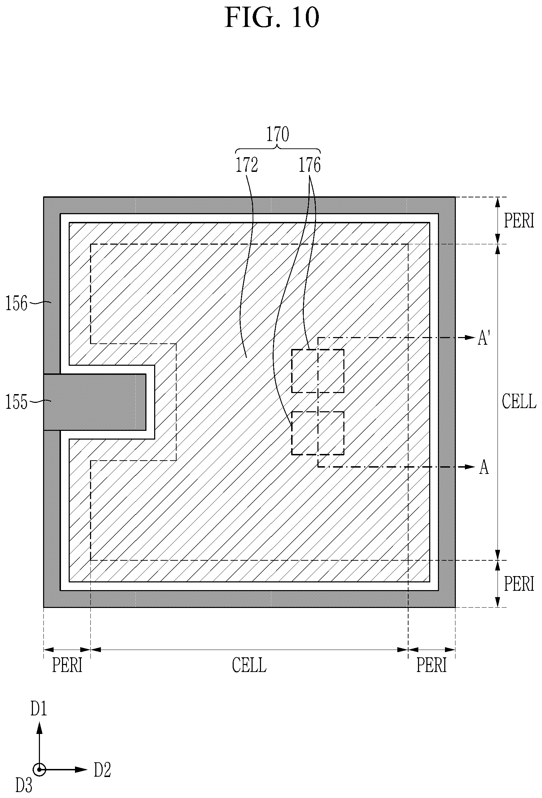

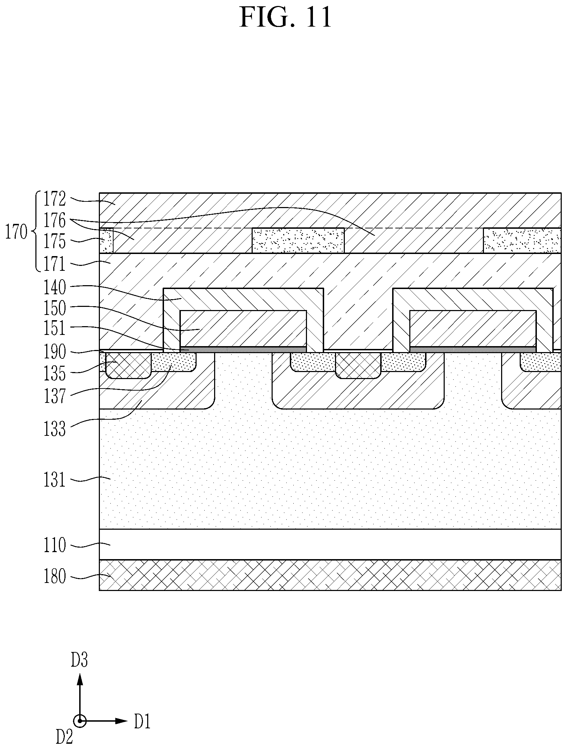

FIG. 10 is a top plan view showing an example of a semiconductor device. FIG. 11 is a cross-sectional view taken along line A-A' of FIG. 10.

The example and views illustrated in FIG. 10 and FIG. 11 are substantially identical or similar to the example and views illustrated in FIG. 8 and FIG. 9, and overlapping description thereof will be omitted and the differences will be mainly explained. Additionally, the same reference numerals are used for the same components.

FIG. 8 and FIG. 9, as described in reference to FIG. 1 and FIG. 2, illustrate a case where the second source electrode 172 has a greater electrical resistance than that of the resistance layer 176. FIG. 10 and FIG. 11 illustrate a case where the second source electrode 172 has an electrical resistance that is greater than or equal to that of the resistance layer 176.

Referring to FIG. 10 and FIG. 11, the resistance layer 176 and the second source electrode 172 may have a greater electrical resistance than that of the first source electrode 171. For example, the resistance layer 176 and the second source electrode 172 may have an electrical resistance that is greater than or equal to 10 times greater than that of the first source electrode 171, for example greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and less than or equal to 100 times greater, for example less than or equal to 90 times greater, less than or equal to 80 times greater less than or equal to 70 times greater, less than or equal to 60 times greater, less than or equal to 50 times greater, less than or equal to 40 times greater, less than or equal to 30 times greater, or less than or equal to 20 times greater, and in some examples greater than or equal to 10 times greater and less than or equal to 100 times greater.

The second source electrode 172 may have an electrical resistance that is the same as the resistance layer 176, or may have an electrical resistance that is greater than or equal to 10 times greater than that of the resistance layer 176, for example greater than or equal to 20 times greater, greater than or equal to 30 times greater, greater than or equal to 40 times greater, greater than or equal to 50 times greater, greater than or equal to 60 times greater, greater than or equal to 70 times greater, greater than or equal to 80 times greater, or greater than or equal to 90 times greater, and less than or equal to 100 times greater, for example less than or equal to 90 times greater, less than or equal to 80 times greater, less than or equal to 70 times greater, less than or equal to 60 times greater, less than or equal to 50 times greater, less than or equal to 40 times greater, less than or equal to 30 times greater, or less than or equal to 20 times greater, and in some examples greater than or equal to 10 times greater and less than or equal to 100 times greater.

The electrical resistance of the second source electrode 172 and the resistance layer 176 may be greater than 10.0×10⁻⁸ Ω m at 0 °C, for example, greater than or equal to 20.0×10⁻⁸ Ω m, greater than or equal to 30.0×10⁻⁸ Ω m, greater than or equal to 40.0×10⁻⁸ Ω m, greater than or equal to 50.0×10⁻⁸ Ω m, greater than or equal to 60.0×10⁻⁸ Ω m, greater than or equal to 70.0×10⁻⁸ Ω m, greater than or equal to 80.0×10⁻⁸ Ω m, or greater than or equal to 90.0×10⁻⁸ Ω m, and less than or equal to 100.0×10⁻⁸ Ω m, for example, less than or equal to 90.0×10⁻⁸ Ω m, less than or equal to 80.0×10⁻⁸ Ω m, less than or equal to 70.0×10⁻⁸ Ω m, less than or equal to 60.0×10⁻⁸ Ω m, less than or equal to 50.0×10⁻⁸ Ω m, less than or equal to 40.0×10⁻⁸ Ω m, less than or equal to 30.0×10⁻⁸ Ω m, or less than or equal to 20.0×10⁻⁸ Ω m, and may be greater than 10.0×10⁻⁸ Ω m and less than or equal to 100.0×10⁻⁸ Ω m.

For example, the second source electrode 172 may include, without being limited thereto, a material having a higher electrical resistance than that of the first source electrode 171. For example, the second source electrode 172 may include palladium (Pd), tin (Sn), tantalum (Ta), chromium (Cr), strontium (St), antimony (Sb), zirconium (Zr), rubidium (Rb), manganese (Mn), polysilicon, tantalum carbonitride (TaCN), tantalum carbide (TaC), tantalum nitride (TaN), tantalum silicon nitride (TaSiN), tantalum titanium nitride (TaTiN), tantalum aluminum nitride (TaAIN), or a combination thereof, and may consist of a single layer or multiple layers.

For example, the source electrode 170 may be formed by forming a resistance layer 176 on a first source electrode 171, forming a second interlayer insulating layer 175 covering the first source electrode 171, etching the second interlayer insulating layer 175 to expose a portion of the first source electrode 171, and forming a resistance layer 176 inside the etched second interlayer insulating layer 175, while simultaneously forming a second source electrode 172 on an upper surface of the second interlayer insulating layer 175. By doing this, the process may be shortened by reducing the number of masks used in the process.

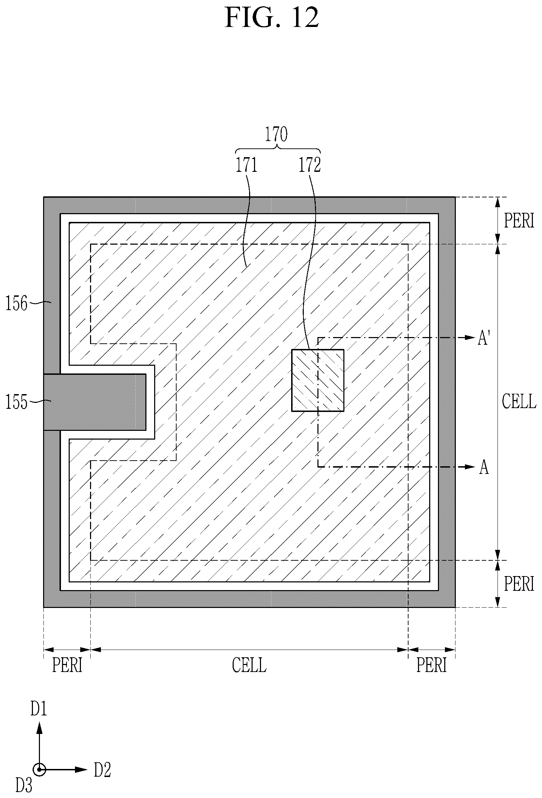

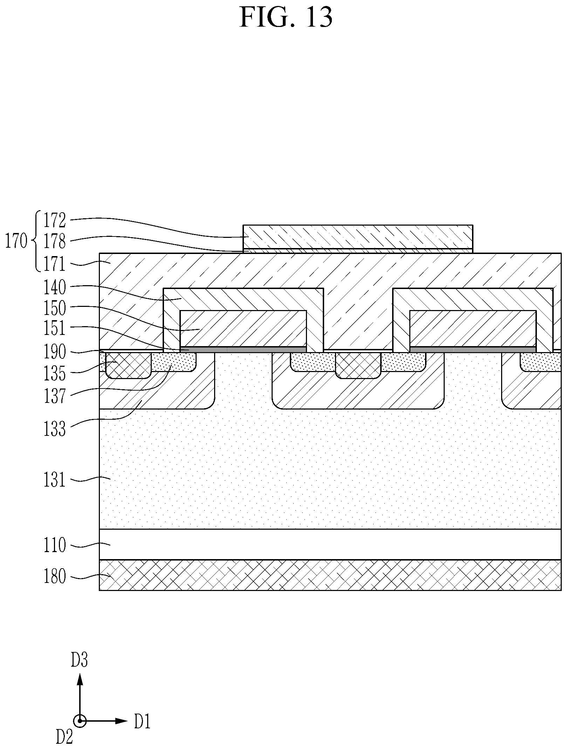

FIG. 12 is a top plan view showing an example of a semiconductor device. FIG. 13 is a cross-sectional view taken along line A-A' of FIG. 12.

The example and views illustrated in FIG. 12 and FIG. 13 are substantially identical or similar to the example and views illustrated in FIG. 1 and FIG. 2, and overlapping description thereof will be omitted and the differences will be mainly explained. Additionally, the same reference numerals are used for the same components.

Referring to FIG. 12 and FIG. 13, the second source electrode 172 is positioned on the first source electrode 171. However, unlike as shown in FIG. 1 and FIG. 2, a resistance layer 176 is not positioned between the first source electrode 171 and the second source electrode 172. In other words, the first source electrode 171 and the second source electrode 172 may be sequentially stacked in the third direction D3.

For example, the bottom surface of the second source electrode 172 may be in direct contact with the upper surface of the first source electrode 171. However, the arrangement is not limited thereto, and in some implementations, a barrier layer 178 may be positioned between the first source electrode 171 and the second source electrode 172. For example, the first source electrode 171, the barrier layer 178, and the second source electrode 172 may be sequentially stacked in the third direction D3.

The barrier layer 178 may prevent the metallic materials of the first source electrode 171 and the second source electrode 172 from being mixed when the second interlayer insulating layer 175 and the resistance layer 176 are not positioned between the first source electrode 171 and the second source electrode 172.

For example, the barrier layer 178 may include titanium (Ti), titanium nitride (TiN), titanium tungsten (Ti-W), platinum (Pt), chromium (Cr), or a combination thereof, for example titanium (Ti), titanium nitride (TiN), or titanium tungsten (Ti-W). The barrier layer 178 may consist of a single layer or multiple layers.

For example, the thickness of the barrier layer 178 may be greater than or equal to 100 nm, for example, greater than or equal to 1 µm, greater than or equal to 2 µm, greater than or equal to 3 µm, greater than or equal to 4 µm, greater than or equal to 5 µm, greater than or equal to 6 µm, greater than or equal to 7 µm, greater than or equal to 8 µm, or greater than or equal to 9 µm, and may be less than or equal to 10 µm, for example, less than or equal to 9 µm, less than or equal to 8 µm, less than or equal to 7 µm, less than or equal to 6 µm, less than or equal to 5 µm, less than or equal to 4 µm, less than or equal to 3 µm, less than or equal to 2 µm, or less than or equal to 1 µm, and in some examples may be greater than or equal to 100 nm and less than or equal to 10 µm, or greater than or equal to 100 nm and less than or equal to 3 µm.

For example, a semiconductor device may be manufactured by forming a first conductivity type semiconductor layer 131 on an upper surface of a substrate 110, forming a second conductivity type doping well region 133 within the first conductivity type semiconductor layer 131, forming a gate insulation layer 151 and a gate electrode 150 on the first conductivity type semiconductor layer 131, forming a source electrode 170 on the second conductivity type doping well region 133, and forming a drain electrode 180 below the bottom surface of the substrate 110. The source electrode 170 may be formed by forming a first source electrode 171 on the gate electrode 150, forming a barrier layer 178 covering the first source electrode 171, and forming a second source electrode 172 on the barrier layer 178.

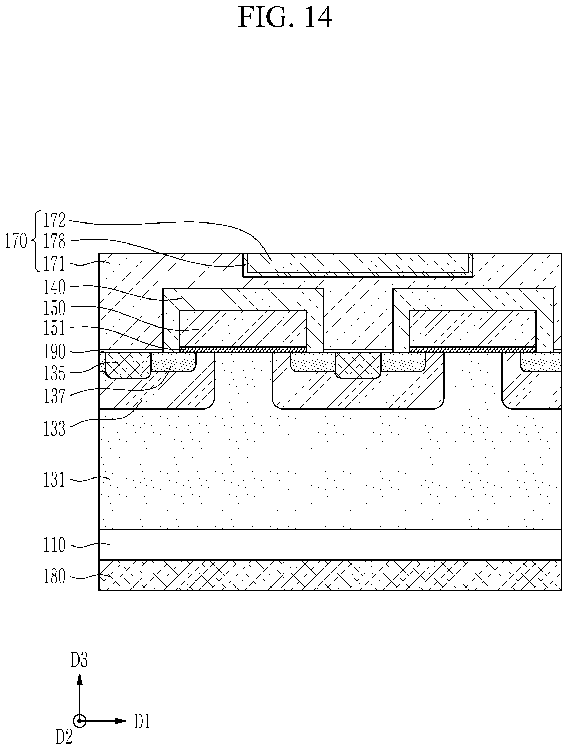

FIG. 14 is a cross-sectional view showing an example of a semiconductor device corresponding to FIG. 13. The example illustrated in FIG. 14 is substantially identical or similar to the example illustrated in FIG. 13, and overlapping description thereof will be omitted and the differences will be mainly explained. Additionally, the same reference numerals are used for the same components.

Referring to FIG. 14, the second source electrode 172 may be positioned within the first source electrode 171. For example, the first source electrode 171 may cover the side of the second source electrode 172. A level in the third direction D3 of the upper surface of the second source electrode 172 may be the same as a level in the third direction D3 of the upper surface of the first source electrode 171. The second source electrode 172 may be positioned within the first source electrode 171.

For example, the bottom surface and side surface of the second source electrode 172 may be covered by the first source electrode 171, and the bottom surface and side surface of the second source electrode 172 may be in direct contact with the first source electrode 171. However, the configuration is not limited thereto, and in some implementations, the barrier layer 178 may be positioned between the first source electrode 171 and the second source electrode 172. In this case, the barrier layer 178 may be positioned between the bottom surface of the second source electrode 172 and the first source electrode 171, and also between the side surface of the second source electrode 172 and the first source electrode 171.

For example, the source electrode 170 may be formed by forming a first source electrode 171 on a gate electrode 150, etching the first source electrode 171, forming a barrier layer 178 inside the etched first source electrode 171, and forming a second source electrode 172 inside the first source electrode 171.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

Although examples have been described in detail above, the scope of the present disclosure is not limited thereto, and various modifications and improvements made by those skilled in the art also fall within the scope of the present disclosure.

Embodiments are set out in the following clauses:
Clause 1. A semiconductor device comprising:
   a substrate;
   a first conductivity type semiconductor layer on an upper surface of the substrate;
   a second conductivity type doping well region within the first conductivity type semiconductor layer;
   a gate electrode on the first conductivity type semiconductor layer;
   a gate insulation layer between the first conductivity type semiconductor layer and the gate electrode;
   a source electrode on the second conductivity type doping well region; and
   a drain electrode below a lower surface of the substrate,
   wherein the source electrode includes:
      a first source electrode on the gate electrode,
      a second source electrode on the first source electrode, and
      a third source electrode on the second source electrode,
      wherein the second source electrode has an electrical resistance that is greater than an electrical resistance of the first source electrode, and
      wherein the third source electrode has an electrical resistance that is greater than the electrical resistance of the second source electrode.
Clause 2. The semiconductor device of clause 1, wherein:
   the electrical resistance of the second source electrode is greater than or equal to 10 times greater than the electrical resistance of the first source electrode, and
   the electrical resistance of the third source electrode is greater than or equal to 10 times greater than the electrical resistance of the second source electrode.
Clause 3. The semiconductor device of clause 2, wherein:
   the electrical resistance of the first source electrode is greater than or equal to 1.0×10⁻⁸ Ω·m and less than or equal to 10.0×10⁻⁸ Ω·m at 0 °C,
   the electrical resistance of the second source electrode is greater than 10.0×10⁻⁸ Ω·m and less than 100.0×10⁻⁸ Ω·m at 0 °C, and
   the electrical resistance of the third source electrode is greater than or equal to 100.0×10⁻⁸ Ω·m and less than or equal to 1000.0×10⁻⁸ Ω·m at 0 °C.
Clause 4. The semiconductor device of any of clauses 1-3, wherein:
   the second source electrode has a smaller lateral area than a lateral area of the first source electrode,
   the third source electrode has a smaller lateral area than the lateral area of the first source electrode,
   the second source electrode is completely overlapped by the first source electrode in a vertical direction,
   the third source electrode is completely overlapped by the first source electrode along the vertical direction,
   the first source electrode is partially overlapped by each of the second source electrode and the third source electrode along the vertical direction, and
   the second source electrode and the third source electrode are partially overlapping with one another along the vertical direction.
Clause 5. A semiconductor device comprising:
   a substrate comprising a cell region and a peripheral region outside the cell region;
   a first conductivity type semiconductor layer on an upper surface of the substrate;
   a second conductivity type doping well region within the first conductivity type semiconductor layer;
   a gate electrode on the first conductivity type semiconductor layer;
   a gate insulation layer between the first conductivity type semiconductor layer and the gate electrode;
   a source electrode on the second conductivity type doping well region; and
   a drain electrode below a lower surface of the substrate,
   wherein the source electrode includes:
      a first source electrode on the gate electrode, and
      a second source electrode on the first source electrode, wherein the second source electrode has an electrical resistance that is greater than an electrical resistance of the first source electrode.
Clause 6. The semiconductor device of clause 5, wherein the source electrode includes:
   a resistance layer between the first source electrode and the second source electrode, wherein the resistance layer includes a conductive material having a greater electrical resistivity than an electrical resistivity of a conductive material of the first source electrode, and
   wherein the electrical resistance of the second source electrode is greater than or equal to an electrical resistance of the resistance layer.
Clause 7. The semiconductor device of clause 6, wherein the electrical resistance of the resistance layer and the electrical resistance of the second source electrode are each greater than or equal to 10 times greater than the electrical resistance of the first source electrode.
Clause 8. The semiconductor device of clause 7, wherein:
   the electrical resistance of the first source electrode is greater than or equal to 1.0×10⁻⁸ Ω·m and less than or equal to 10.0×10⁻⁸ Ω·m at 0 °C, and
   the electrical resistance of the resistance layer and the electrical resistance of the second source electrode are each greater than 10.0×10⁻⁸ Ω·m and less than or equal to 100.0×10⁻⁸ Ω·m at 0 °C.
Clause 9. The semiconductor device of any of clauses 6 to 8, wherein:
   the first source electrode has a greater lateral area than a lateral area of the cell region,
   the second source electrode has a smaller lateral area than at least one of the lateral area of the first source electrode or the lateral area of the cell region,
   the resistance layer has a smaller lateral area than the lateral area of the first source electrode and the lateral area of the second source electrode,
   the resistance layer is completely overlapped by the second source electrode in a vertical direction, and
   the second source electrode is partially overlapped by the resistance layer along the vertical direction.
Clause 10. The semiconductor device of clause 5, wherein the source electrode includes a barrier layer between the first source electrode and the second source electrode.
Clause 11. The semiconductor device of clause 10, wherein the barrier layer includes titanium (Ti), titanium nitride (TiN), titanium tungsten (Ti-W), platinum (Pt), chromium (Cr), or a combination thereof.
Clause 12. The semiconductor device of any of clauses 5, 10, or 11, wherein:
   the first source electrode covers a side surface of the second source electrode,
   a vertical level of an upper surface of the first source electrode is a same as a vertical level of an upper surface of the second source electrode, and
   the second source electrode is within the first source electrode.

## Claims

1. A semiconductor device comprising:
a substrate (110);
a first conductivity type semiconductor layer (131) on an upper surface of the substrate (110);
a second conductivity type doping well region (133) within the first conductivity type semiconductor layer (131);
a gate electrode (150) on the first conductivity type semiconductor layer (131);
a gate insulation layer (151) between the first conductivity type semiconductor layer (131) and the gate electrode (150);
a source electrode (170) on the second conductivity type doping well region (133); and
a drain electrode (180) below a lower surface of the substrate (110),
wherein the source electrode (170) includes:
a first source electrode (171) on the gate electrode (150) and comprising a first conductive material,
a second source electrode (172) on the first source electrode (171), and
a resistance layer (176) between the first source electrode (171) and the second source electrode (172), wherein the resistance layer (176) comprises a second conductive material having a greater electrical resistivity than an electrical resistivity of the first conductive material.

2. The semiconductor device of claim 1, wherein the resistance layer (176) has an electrical resistance greater than or equal to 10 times greater than an electrical resistance of the first source electrode (171), and
wherein the second source electrode (172) has an electrical resistance greater than or equal to 10 times greater than the electrical resistance of the resistance layer (176).

3. The semiconductor device of claim 1 or claim 2, wherein:
an electrical resistance of the first source electrode (171) is greater than or equal to 1.0×10⁻⁸ Ω·m and less than or equal to 10.0×10⁻⁸ Ω·m at 0°C,
an electrical resistance of the resistance layer (176) is greater than 10.0×10⁻⁸ Ω·m and less than 100.0×10⁻⁸ Ω·m at 0°C, and
an electrical resistance of the second source electrode (172) is greater than or equal to 100.0×10⁻⁸ Ω·m and less than or equal to 1000.0×10⁻⁸ Ω·m at 0°C.

4. The semiconductor device of any preceding claim, wherein:
the second source electrode (172) has a smaller lateral area than a lateral area of the first source electrode (171),
the resistance layer (176) has a smaller lateral area than the lateral area of the first source electrode (171),
the second source electrode (172) is completely overlapped by the first source electrode (171) along a vertical direction (D3),
the resistance layer (176) is completely overlapped by the first source electrode (171) along the vertical direction (D3),
the first source electrode (171) is partially overlapped by each of the second source electrode (172) and the resistance layer (176) along the vertical direction (D3), and
the second source electrode (172) and the resistance layer (176) are partially overlapping with one another along the vertical direction (D3).

5. The semiconductor device of any preceding claim, comprising a second interlayer insulating layer (175) on the first source electrode (171),
wherein the second interlayer insulating layer (175) covers an upper surface of the first source electrode (171) and a side surface of the resistance layer (176),
wherein a vertical level of an upper surface of the second interlayer insulating layer (175) is a same as a vertical level of an upper surface of the resistance layer (176),
wherein the resistance layer (176) is within the second interlayer insulating layer (175), and
wherein the second source electrode (172) is on the second interlayer insulating layer (175).

6. The semiconductor device of any of claims 1-4, comprising a second interlayer insulating layer (175) on the first source electrode (171),
wherein the second interlayer insulating layer (175) covers an upper surface of the first source electrode (171), an upper surface and a side surface of the resistance layer (176), and a side surface of the second source electrode (172),
wherein a vertical level of an upper surface of the second interlayer insulating layer (175) is a same as a vertical level of the upper surface of the second source electrode (172), and
wherein the resistance layer (176) and the second source electrode (172) are within the second interlayer insulating layer (175).

7. The semiconductor device of any preceding claim, wherein:
the source electrode (170) includes a plurality of second source electrodes (172_1, 172_2, 172_3) and a plurality of resistance layers (176_1, 176_2, 176_3), wherein the plurality of second source electrodes (172_1, 172_2, 172_3) includes the second source electrode (172), and wherein the plurality of resistance layers (176_1, 176_2, 176_3) includes the resistance layer (176),
wherein the plurality of second source electrodes (172_1, 172_2, 172_3) and the plurality of resistance layers (176_1, 176_2, 176_3) are alternately stacked along a vertical direction (D3),
wherein respective electrical resistances of the plurality of second source electrodes (172_1, 172_2, 172_3) increase with increasing height along the vertical direction (D3), and
wherein respective electrical resistances of the plurality of resistance layers (176_1, 176_2, 176_3) increase with increasing height along the vertical direction (D3).

8. The semiconductor device of claim 7, wherein the plurality of second source electrodes (172_1, 172_2, 172_3) includes at least two layers and less than or equal to 100 layers of the plurality of second source electrodes (172_1, 172_2, 172_3) along the vertical direction (D3), and
wherein the plurality of resistance layers (176_1, 176_2, 176_3) includes at least two layers and less than or equal to 100 layers of the plurality of resistance layers (176_1, 176_2, 176_3) along the vertical direction (D3).

9. A semiconductor device comprising:
a substrate (110);
a first conductivity type semiconductor layer (131) on an upper surface of the substrate (110);
a second conductivity type doping well region (133) within the first conductivity type semiconductor layer (131);
a gate electrode (150) on the first conductivity type semiconductor layer (131);
a gate insulation layer (151) between the first conductivity type semiconductor layer (131) and the gate electrode (150);
a source electrode (170) on the second conductivity type doping well region (133); and
a drain electrode (180) below a lower surface of the substrate (110),
wherein the source electrode (170) includes:
a first source electrode (171) on the gate electrode (150),
a second source electrode (172) on the first source electrode (171), and
a third source electrode (173) on the second source electrode (172),
wherein the second source electrode (172) has an electrical resistance that is greater than an electrical resistance of the first source electrode (171), and
wherein the third source electrode (173) has an electrical resistance that is greater than the electrical resistance of the second source electrode (172).

10. The semiconductor device of claim 9, wherein:
the electrical resistance of the second source electrode (172) is greater than or equal to 10 times greater than the electrical resistance of the first source electrode (171), and
the electrical resistance of the third source electrode (173) is greater than or equal to 10 times greater than the electrical resistance of the second source electrode (172).

11. The semiconductor device of claim 10, wherein:
the electrical resistance of the first source electrode (171) is greater than or equal to 1.0×10⁻⁸ Ω·m and less than or equal to 10.0×10⁻⁸ Ω·m at 0 °C,
the electrical resistance of the second source electrode (172) is greater than 10.0×10⁻⁸ Ω·m and less than 100.0×10⁻⁸ Ω·m at 0 °C, and
the electrical resistance of the third source electrode (173) is greater than or equal to 100.0×10⁻⁸ Ω·m and less than or equal to 1000.0×10⁻⁸ Ω·m at 0 °C.

12. The semiconductor device of any of claims 9-11, wherein:
the second source electrode (172) has a smaller lateral area than a lateral area of the first source electrode (171),
the third source electrode (173) has a smaller lateral area than the lateral area of the first source electrode (171),
the second source electrode (172) is completely overlapped by the first source electrode (171) in a vertical direction (D3),
the third source electrode (173) is completely overlapped by the first source electrode (171) along the vertical direction (D3),
the first source electrode (171) is partially overlapped by each of the second source electrode (172) and the third source electrode (173) along the vertical direction (D3), and
the second source electrode (172) and the third source electrode (173) are partially overlapping with one another along the vertical direction (D3).

13. A semiconductor device comprising:
a substrate (110) comprising a cell region (CELL) and a peripheral region (PERI) outside the cell region (CELL);
a first conductivity type semiconductor layer (131) on an upper surface of the substrate (110);
a second conductivity type doping well region (133) within the first conductivity type semiconductor layer (131);
a gate electrode (150) on the first conductivity type semiconductor layer (131);
a gate insulation layer (151) between the first conductivity type semiconductor layer (131) and the gate electrode (150);
a source electrode (170) on the second conductivity type doping well region (133); and
a drain electrode (180) below a lower surface of the substrate (110),
wherein the source electrode (170) includes:
a first source electrode (171) on the gate electrode (150), and
a second source electrode (172) on the first source electrode (171), wherein the second source electrode (172) has an electrical resistance that is greater than an electrical resistance of the first source electrode (171).

14. The semiconductor device of claim 13, wherein the source electrode (170) includes a barrier layer (178) between the first source electrode (171) and the second source electrode (172),
optionally wherein the barrier layer (178) includes titanium (Ti), titanium nitride (TiN), titanium tungsten (Ti-W), platinum (Pt), chromium (Cr), or a combination thereof.

15. The semiconductor device of claim 13 or claim 14, wherein:
the first source electrode (171) covers a side surface of the second source electrode (172),
a vertical level of an upper surface of the first source electrode (171) is a same as a vertical level of an upper surface of the second source electrode (172), and
the second source electrode (172) is within the first source electrode (171).

## Amended claims

### Amended claims in accordance with Rule 137(2) EPC.

1. A semiconductor device comprising:
a substrate (110);
a first conductivity type semiconductor layer (131) on an upper surface of the substrate (110);
a second conductivity type doping well region (133) within the first conductivity type semiconductor layer (131);
a gate electrode (150) on the first conductivity type semiconductor layer (131);
a gate insulation layer (151) between the first conductivity type semiconductor layer (131) and the gate electrode (150);
a source electrode (170) on the second conductivity type doping well region (133); and
a drain electrode (180) below a lower surface of the substrate (110),
wherein the source electrode (170) includes:
a first source electrode (171) on the gate electrode (150) and comprising a first conductive material,
a second source electrode (172) on the first source electrode (171), and
a resistance layer (176) between the first source electrode (171) and the second source electrode (172), wherein the resistance layer (176) comprises a second conductive material having a greater electrical resistivity than an electrical resistivity of the first conductive material,
wherein the resistance layer (176) has a smaller lateral area than the lateral area of the first source electrode (171).

2. The semiconductor device of claim 1, wherein the resistance layer (176) has an electrical resistivity greater than or equal to 10 times greater than an electrical resistivity of the first source electrode (171), and
wherein the second source electrode (172) has an electrical resistivity greater than or equal to 10 times greater than the electrical resistivity of the resistance layer (176).

3. The semiconductor device of claim 1 or claim 2, wherein:
an electrical resistivity of the first source electrode (171) is greater than or equal to 1.0×10⁻⁸ Ω·m and less than or equal to 10.0×10⁻⁸ Ω·m at 0°C,
an electrical resistivity of the resistance layer (176) is greater than 10.0×10⁻⁸ Ω·m and less than 100.0×10⁻⁸ Ω·m at 0°C, and
an electrical resistivity of the second source electrode (172) is greater than or equal to 100.0×10⁻⁸ Ω·m and less than or equal to 1000.0×10⁻⁸ Ω·m at 0°C.

4. The semiconductor device of any preceding claim, wherein:
the second source electrode (172) has a smaller lateral area than a lateral area of the first source electrode (171),
the second source electrode (172) is completely overlapped by the first source electrode (171) along a vertical direction (D3),
the resistance layer (176) is completely overlapped by the first source electrode (171) along the vertical direction (D3),
the first source electrode (171) is partially overlapped by each of the second source electrode (172) and the resistance layer (176) along the vertical direction (D3), and
the second source electrode (172) and the resistance layer (176) are partially overlapping with one another along the vertical direction (D3).

5. The semiconductor device of any preceding claim, comprising a second interlayer insulating layer (175) on the first source electrode (171),
wherein the second interlayer insulating layer (175) covers an upper surface of the first source electrode (171) and a side surface of the resistance layer (176),
wherein a vertical level of an upper surface of the second interlayer insulating layer (175) is a same as a vertical level of an upper surface of the resistance layer (176),
wherein the resistance layer (176) is within the second interlayer insulating layer (175), and
wherein the second source electrode (172) is on the second interlayer insulating layer (175).

6. The semiconductor device of any of claims 1-4, comprising a second interlayer insulating layer (175) on the first source electrode (171),
wherein the second interlayer insulating layer (175) covers an upper surface of the first source electrode (171), an upper surface and a side surface of the resistance layer (176), and a side surface of the second source electrode (172),
wherein a vertical level of an upper surface of the second interlayer insulating layer (175) is a same as a vertical level of the upper surface of the second source electrode (172), and
wherein the resistance layer (176) and the second source electrode (172) are within the second interlayer insulating layer (175).

7. The semiconductor device of any preceding claim, wherein:
the source electrode (170) includes a plurality of second source electrodes (172_1, 172_2, 172_3) and a plurality of resistance layers (176_1, 176_2, 176_3), wherein the plurality of second source electrodes (172_1, 172_2, 172_3) includes the second source electrode (172), and wherein the plurality of resistance layers (176_1, 176_2, 176_3) includes the resistance layer (176),
wherein the plurality of second source electrodes (172_1, 172_2, 172_3) and the plurality of resistance layers (176_1, 176_2, 176_3) are alternately stacked along a vertical direction (D3),
wherein respective electrical resistivities of the plurality of second source electrodes (172_1, 172_2, 172_3) increase with increasing height along the vertical direction (D3), and
wherein respective electrical resistivities of the plurality of resistance layers (176_1, 176_2, 176_3) increase with increasing height along the vertical direction (D3).

8. The semiconductor device of claim 7, wherein the plurality of second source electrodes (172_1, 172_2, 172_3) includes at least two layers and less than or equal to 100 layers of the plurality of second source electrodes (172_1, 172_2, 172_3) along the vertical direction (D3), and
wherein the plurality of resistance layers (176_1, 176_2, 176_3) includes at least two layers and less than or equal to 100 layers of the plurality of resistance layers (176_1, 176_2, 176_3) along the vertical direction (D3).

9. The semiconductor device of claim 1, comprising:
a third source electrode (173) on the second source electrode (172),
wherein the second source electrode (172) has an electrical resistivity that is greater than an electrical resistivity of the first source electrode (171), and
wherein the third source electrode (173) has an electrical resistivity that is greater than the electrical resistivity of the second source electrode (172).

10. The semiconductor device of claim 9, wherein:
the electrical resistivity of the second source electrode (172) is greater than or equal to 10 times greater than the electrical resistivity of the first source electrode (171), and
the electrical resistivity of the third source electrode (173) is greater than or equal to 10 times greater than the electrical resistivity of the second source electrode (172).

11. The semiconductor device of claim 10, wherein:
the electrical resistivity of the first source electrode (171) is greater than or equal to 1.0×10⁻⁸ Ω·m and less than or equal to 10.0×10⁻⁸ Ω·m at 0 °C,
the electrical resistivity of the second source electrode (172) is greater than 10.0×10⁻⁸ Ω·m and less than 100.0×10⁻⁸ Ω·m at 0 °C, and
the electrical resistivity of the third source electrode (173) is greater than or equal to 100.0×10⁻⁸ Ω·m and less than or equal to 1000.0×10⁻⁸ Ω·m at 0 °C.

12. The semiconductor device of any of claims 9-11, wherein:
the second source electrode (172) has a smaller lateral area than a lateral area of the first source electrode (171),
the third source electrode (173) has a smaller lateral area than the lateral area of the first source electrode (171),
the second source electrode (172) is completely overlapped by the first source electrode (171) in a vertical direction (D3),
the third source electrode (173) is completely overlapped by the first source electrode (171) along the vertical direction (D3),
the first source electrode (171) is partially overlapped by each of the second source electrode (172) and the third source electrode (173) along the vertical direction (D3), and
the second source electrode (172) and the third source electrode (173) are partially overlapping with one another along the vertical direction (D3).

13. A semiconductor device comprising:
a substrate (110) comprising a cell region (CELL) and a peripheral region (PERI) outside the cell region (CELL);
a first conductivity type semiconductor layer (131) on an upper surface of the substrate (110);
a second conductivity type doping well region (133) within the first conductivity type semiconductor layer (131);
a gate electrode (150) on the first conductivity type semiconductor layer (131);
a gate insulation layer (151) between the first conductivity type semiconductor layer (131) and the gate electrode (150);
a source electrode (170) on the second conductivity type doping well region (133); and
a drain electrode (180) below a lower surface of the substrate (110),
wherein the source electrode (170) includes:
a first source electrode (171) on the gate electrode (150), and
a second source electrode (172) on the first source electrode (171), wherein the second source electrode (172) has an electrical resistivity that is greater than an electrical resistivity of the first source electrode (171),
wherein the second source electrode (172) has a smaller lateral area than a lateral area of the first source electrode (171).

14. The semiconductor device of claim 13, wherein the source electrode (170) includes a barrier layer (178) between the first source electrode (171) and the second source electrode (172),
optionally wherein the barrier layer (178) includes titanium (Ti), titanium nitride (TiN), titanium tungsten (Ti-W), platinum (Pt), chromium (Cr), or a combination thereof.

15. The semiconductor device of claim 13 or claim 14, wherein:
the first source electrode (171) covers a side surface of the second source electrode (172),
a vertical level of an upper surface of the first source electrode (171) is a same as a vertical level of an upper surface of the second source electrode (172), and
the second source electrode (172) is within the first source electrode (171).
